# EUROPEAN PATENT SPECIFICATION

(11) **EP 0 644 650 B1**
(45) Date of publication and mention of the grant of the patent: **14.10.1998**
(21) Application number: 94117669.5
(22) Date of filing: 06.02.1991
(51) Int. Cl.: H03F 3/60, H03F 1/34

(54) **Constant-amplitude wave combination type amplifier**
Verstärker für kombinierte Wellen mit konstanter Amplitude
Amplificateur pour ondes d'amplitude constante combinée

(30) Priority: 07.02.1990 JP 27698/90; 07.02.1990 JP 27699/90; 07.02.1990 JP 27700/90
(43) Date of publication of application: 22.03.1995
(62) Divisional of application: 91101602.0
(73) Proprietor: FUJITSU LIMITED, Kawasaki-shi, Kanagawa 211 (JP)
(72) Inventor: Okubo, Naofumi, Kawasaki-shi, Kanagawa, 212 (JP); Asano, Yoshihiko, Ohta-ku, Tokyo, 146 (JP); Kurihara, Hiroshi, Suginami-ku, Tokyo, 166 (JP); Daido, Yoshimasa, Yokohama-shi, Kanagawa, 241 (JP); Kobayashi, Kazuhiko, Kawasaki-shi, Kanagawa, 214 (JP); Kobayakawa, Shuji, Yokohama-shi, Kanagawa, 240 (JP); Maniwa, Toru, Kawasaki-shi, Kanagawa, 211 (JP)
(74) Representative: Lehn, Werner, Dipl.-Ing.

(56) References cited:
- GB-A- 2 010 039
- US-A- 3 909 742
- US-A- 4 490 684
- US-A- 4 656 434

## Description

### BACKGROUND OF THE INVENTION

The present invention generally relates to a constant-amplitude wave combination type amplifier, and more particularly to a constant-amplitude wave combination type amplifier based on a LINC (linear amplification with non-linear components) process.

US-A-3 909 742 discloses an amplifier for linearly amplifying a bandpass high frequency analog input signal by a plurality of amplifying means including those having a non-linear characteristic. These amplifying means include first combining means for producing from the input signal first and second signal components having constant amplitude but differing in phase, first and second non-linear amplifiers for separately amplifying said first and second component signals, second combining means for recombining the amplified first and second component signals output by said first and second amplifiers, respectively, so as to generate an output signal formed by the difference of said first and second amplified component signals and being a linearly amplified replica of the input signal, and to also generate a feedback signal being the sum of said first and second amplified component signals and fed to said first combining means for combining the input and feedback signal.

Moreover, constant-amplitude wave combination type amplifiers have been widely used in various communication devices, such as radio devices for use in mobile communications, multiple radio devices, satellite communication radio devices, and broadcasting devices. There is a need to realize such constant-amplitude wave combination amplifiers which consume a small amount of power and which are configured of a small number of structural elements.

Constant-amplitude wave combination type amplifiers based on the LINC process are known as amplifiers which meet the above-mentioned need, and are disclosed in, for example, D.C. Cox, "Linear simplification with Non-linear Components", IEEE Transactions on Communications, December 1974, pp. 1942-1945. An application of constant-amplitude wave combination type amplifier based on the LINC process is proposed in Japanese Laid-Open Patent Application No. 1-284106.

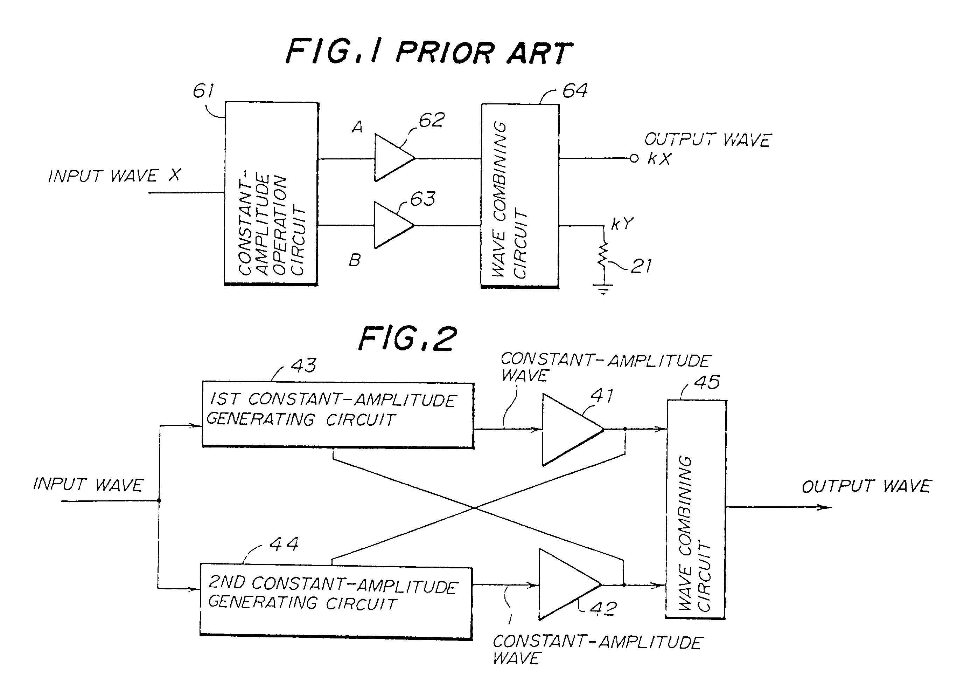

FIG.1 shows a conventional constant-amplitude wave combination type amplifier. As shown, the amplifier has a constant-amplitude wave operation circuit 61, two amplifiers 62 and 63, and a wave combining circuit 64. The constant-amplitude wave operation circuit 61 is formed of a digital signal processing circuit, and calculates an orthogonal wave Y orthogonal to an input wave X so that each combined wave obtained by combining the waves X and Y with each other has a constant amplitude. Then, the constant-amplitude wave operation circuit 61 outputs constant-amplitude waves A and 3 which have constant envelopes having equal amplitudes by the above-mentioned combination of the waves X and Y. Capital letters X, Y, A and 3 are vector amounts which include phases.

The amplifiers 62 and 63, which are formed of non-linear amplifiers such as C-class amplifiers, amplify the constant-amplitude waves A and B, respectively. The wave combining circuit 64 combines constant amplitude waves kA and kB respectively output by the amplifiers 62 and 63, and generates an output wave kX which is an amplified version of the input wave X.

The conventional configuration shown in FIG.1 has an advantage in that the amplifiers 62 and 63 are not required to be formed of linear amplifiers, since it is sufficient to amplify the constant-amplitude waves A and 3 of the constant envelopes. In addition, since the original signal can be reproduced by the wave combining circuit 64, it is possible to linearly amplify the input wave X having little distortion irrespective of the use of the non-linear amplifiers.

As has been described previously, the constant-amplitude wave operation circuit 61 is formed of a digital signal processing circuit. However, the digital signal processing circuit consumes a large amount of power and is not suitable for high-speed signal processing. Further, the use of the digital signal processing circuit causes an increase in the size of the amplifier. For the above reasons, the use of conventional constant-amplitude wave combination type amplifiers is limited to special applications in which the amount of power consumed in the digital signal processing circuit or the size of the amplifier are negligible, or applications in which data is transferred at a low speed.

### SUMMARY OF THE INVENTION

It is a general object of the present invention to provide an improved constant-amplitude wave combination type amplifier which the above-mentioned disadvantages are eliminated.

A more specific object of the present invention is to provide a constant-amplitude wave combination type amplifier which consumes a small amount of power, is formed of a small number of structural elements and operates at a high speed.

According to the present invention, the above-mentioned objects are achieved by a constant-amplitude wave combination type amplifier as specified in claim 1.

Further improvements according to the present invention are specified in claims 2 to 25 being dependent on claim 1.

### BRIEF DESCRIPTION OF THE DRAWINGS

The objects, features and advantages of the present invention will become more apparent from the following detailed description when read in conjuncton with the accompanied drawings showing in
Fig. 1 a block diagram of a conventional constant-amplitude wave combination type amplifier;
FIG,2 is a block diagram illustrating an outline of a constant-amplitude wave combination type amplifier according to an embodiment disclosed for explanation of the present invention;
FIG.3 is a block diagram illustrating the configuration shown in FIG.2 in more detail;
FIG.4 is a graph illustrating the principle of the operation of the configuration shown in FIG.3;
FIG.5 is a block diagram illustrating the operation of the configuration shown in FIG.3;
FIG.6 is a block diagram illustrating a variation of the configuration shown in FIG.3;
FIG.7 is a block diagram illustrating an outline of a constant-amplitude wave combination type amplifier according to a further embodiment disclosed for explanation of the present invention;
FIG.8 is a block diagram illustrating the configuration shown in FIG.7 in more detail;
FIG.9 is a block diagram illustrating the operation of the configuration shown in FIG.8;
FIG.10 is a block diagram illustrating an outline of a constant-amplitude wave combination type amplifier according to a first preferred embodiment of the present invention;
FIG.11 is a block diagram illustrating the configuration shown in FIG.10 in more detail;
FIG.12 is a graph of an input/output characteristic of an approximate solution circuit shown in FIG.11;
FIG.13 is a graph illustrating an input/output characteristic of a limiter amplifier used in the approximate solution circuit shown in FIG.11;
FIG.14 is a block diagram of a variation of the configuration shown in FIG.11;
FIG.15 is a block diagram illustrating an outline of a constant-amplitude wave combination type amplifier according to a second preferred embodiment of the present invention;
FIG.16 is a block diagram illustrating the configuration shown in FIG.15 in more detail;
FIG.17 is a block diagram illustrating an outline of a constant-amplitude wave combination type amplifier according to a third preferred embodiment of the present invention;
FIG.18 is a block diagram illustrating the configuration shown in FIG.17 in more detail;
FIG.19 is a block diagram illustrating the operation of the configuration shown in FIG.18;
FIG.20 is a block diagram illustrating a variation of the configuration shown in FIG.19;
FIG.21 is a block diagram illustrating an outline of a constant-amplitude wave combination type amplifier according to a fourth preferred embodiment of the present invention;
FIG.22 is a block diagram illustrating the configuration shown in FIG.21 in more detail;
FIG.23 is a block diagram illustrating a variation of the configuration shown in FIG.22;
FIG.24 is a block diagram illustrating an outline of a constant-amplitude wave combination type amplifier according to a fifth preferred embodiment of the present invention;
FIG.25 is a block diagram illustrating the configuration shown in FIG.24 in more detail;
FIG.26 is a block diagram illustrating a variation of the configuration shown in FIG.25;
FIG.27 is a block diagram of a constant-amplitude wave combination type amplifier according to an sixth preferred embodiment of the present invention;
FIG.28 is a block diagram illustrating the configuration shown in FIG.27 in more detail;
FIG.29 is a block diagram illustrating an outline of a constant-amplitude wave combination type amplifier according to a seventh preferred embodiment of the present invention;
FIG.30 is a block diagram illustrating the configuration shown in FIG.29 in more detail;
FIG.31 is a block diagram illustrating an outline of a constant-amplitude amplitude wave combination type amplifier according to an eighth preferred embodiment of the present invention;
FIG.32 is a block diagram illustrating the configuration shown in FIG.31 in more detail;
FIG.33 is a block diagram illustrating an outline of a constant-amplitude wave combination type amplifier according to an ninth preferred embodiment of the present invention; and
FIG.34 is a block diagram illustrating the configuration shown in FIG.33 in more detail.

### DESCRIPTION OF THE PREFERRED EMBODIMENTS

FIG.2 shows an outline of a constant-amplitude wave combination type amplifier according to an embodiment described hereinbelow for better understanding of the present invention. The amplifier shown in FIG.2 has a first constant-amplitude wave generating circuit 43, a second constant-amplitude wave generating circuit 44, first and second amplifiers 41 and 42, and a wave combining circuit 45. The first constant-amplitude wave generating circuit 43 combines an amplified output from the second amplifier 42 and an input wave, and generates a first constant-amplitude wave. The second constant-amplitude wave generating circuit 44 combines an amplified output from the first amplifier 41 and the input wave, and generates a second constant-amplitude wave. The first and second amplifiers 41 and 42 amplify the first and second constant-amplitude waves output by the first and second constant-amplitude wave generating circuits 43 and 44, respectively. The wave combining circuit 45 combines the amplified outputs from the first and second amplifiers 41 and 42, and generates an output wave.

The amplified output from the first amplifier 41 is fed back to the input of the second amplifier 42 via the second constant-amplitude wave generating circuit 44. Similarly, the amplified output from the second amplifier 42 is fed back to the input of the first amplifier 41 via the first constant-amplitude wave generating circuit 43. Thus, the circuit shown in FIG.2 is stable in an oscillation state. In the stable oscillation state, the first and second constant-amplitude waves respectively generated by the first and second constant-amplitude wave generating circuits 43 and 44 have envelopes having constant amplitudes. As a result, it become possible to form the first and second amplifiers 41 and 42 of high-efficient non-linear amplifiers. It is also possible to form the first and second constant-amplitude wave generating circuits 43 and 44 of analog circuits. As a result, the configuration shown in FIG.2 consumes a small amount of power, operates at a high speed and can be formed of a small number of structural elements.

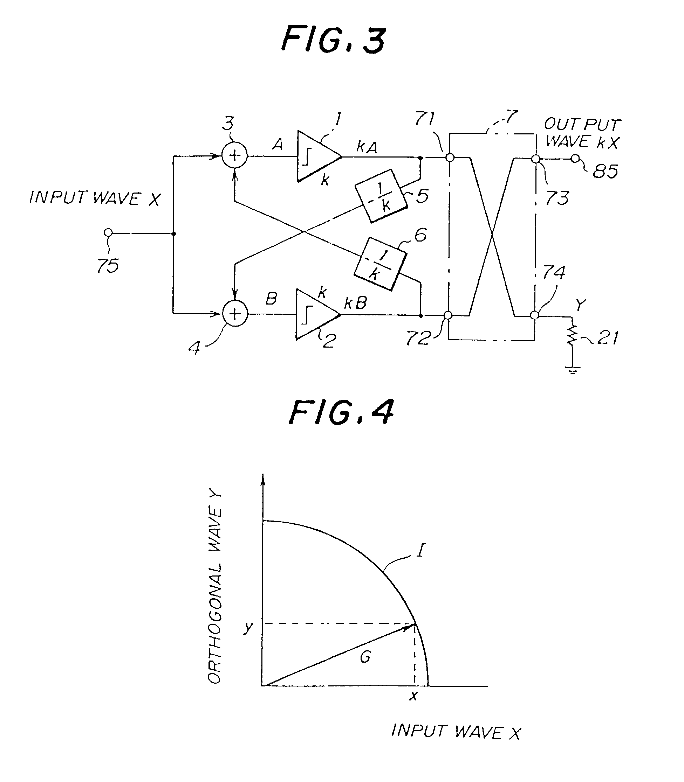

FIG.3 shows the configuration of the amplifier shown in FIG.2 in more detail. The configuration shown in FIG.3 has amplifiers 1 and 2, which correspond to the first and second amplifiers 41 and 42 shown in FIG.3, respectively.- The amplifiers 1 and 2 are formed of amplifiers, each having an amplification gain 'k', and receive constant-amplitude waves A and B, respectively. The amplifiers 1 and 2 can be formed of high-efficient non-linear amplifiers, such as C-class amplifiers. An amplified output kA from the amplifier 1 is input to an attenuator 5 and an input terminal 71 of an in-phase hybrid circuit 7 corresponding to the wave combining circuit 45 shown in FIG.2. An amplified output kB from the amplifier 2 is input to an attenuator 6 and an input terminal 72 of the in-phase hybrid circuit 7.

The attenuator 5 attenuates the amplified signal kA by -1/k. Similarly, the attenuator 6 attenuates the amplified signal kB by -1/k. An output signal of the attenuator 5 is input to an adder 4 corresponding to the first constant-amplitude wave generating circuit 43 shown in FIG.2, and an output signal of the attenuator 6 is input to an adder 3 corresponding to the second constant-amplitude wave generating circuit 44 shown in FIG.2. An input wave X is applied to the adders 3 and 4 via an input terminal 75. The adder 3 adds the input wave X and the amplified signal kB passing through the attenuator 6, and generates the constant-amplitude wave A, which is input to the amplifier 1. Similarly, the adder 4 adds the input wave X and the amplified signal kA passing through the attenuator 5, and generates the constant-amplitude wave B, which is input to the amplifier 2. It will be noted that the adders 3 and 4 and the hybrid circuit 4 can be formed of analog circuits.

The in-phase hybrid circuit 7 receives the amplified signals kA and kB via the input terminals 71 and 72, respectively, and branches each of the amplified signals kA and kB into two signals. Then, the in-phase hybrid circuit 7 outputs an output wave kX obtained by combining the constant-amplitude waves kA/2 and kB/2 with each other to an output terminal 73 and outputs an output wave X to an output terminal 74 so that the output waves kX and Y are in phase with each other. The output wave kX is supplied to an external circuit via an output terminal 85. The output wave Y obtained at the output terminal 74 is terminated via a resistor 21. The input wave X and the wave Y are orthogonal to each other.

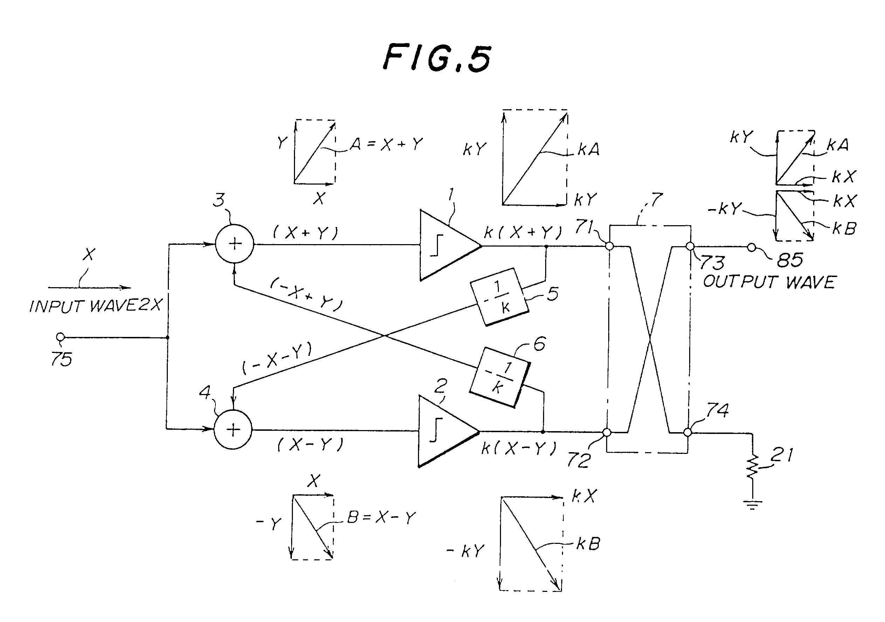

A description will now be given of the operation of the amplifier shown in FIG.3 with reference to FIGS.4 and 5. The orthogonal wave Y is assumed so that a combined vector wave obtained by combining the input wave X and the orthogonal wave Y has a constant amplitude. As shown in FIG.4, when the combined vector wave (now labeled G) obtained by combining the waves X and Y has a constant amplitude, the vector locus of the combined vector wave G moves on a part of a circle illustrated by the solid line indicated by I.

As has been described previously, the amplified signals kA and kB are fed back to the amplifiers 2 and 1 via the attenuators 5 and 6, respectively. Thus, the circuit shown in FIG.3 starts to oscillate and become stable in an oscillation state.

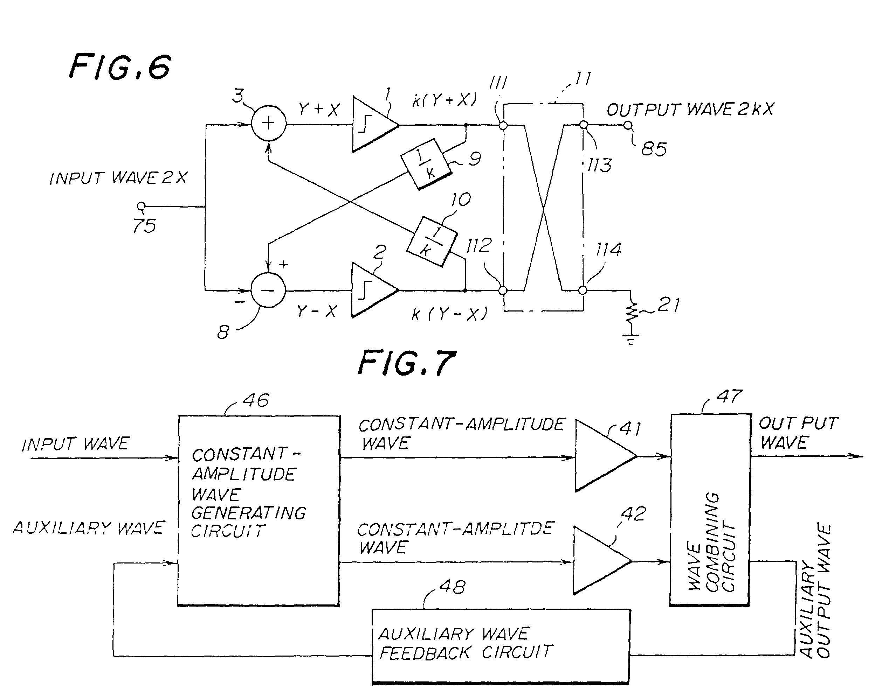

FIG.7 shows the amplitudes of signals which are obtained at nodes of the circuit shown in FIG.3 in a case where the input waveform has an amplitude 2X and which are represented by the assumed orthogonal wave Y. As shown in FIG.7, the output of the adder 3 is (X + Y), the output of the amplifier 1 is k(X + Y), the output of the adder 4 is (X - Y), the output of the attenuator 5 is (-X - Y), the output of the attenuator 6 is (-X + Y), and the output of the in-phase hybrid circuit 7 at its output terminal 73 is 2kX. In the above states, the circuit shown in FIG.3 stably oscillates. FIG.5 also illustrates the phase relationships between the signals at the nodes of the amplifier.

In the stable oscillation state, the output of the adder 3 is the combined vector wave obtained by combining the input wave X and the orthogonal wave Y orthogonal to the input wave X, and the combined vector wave is the constant-amplitude wave A (- X + Y) having the constant amplitude, as has been described with reference to FIG.4. Similarly, the output of the adder 4 is the combined vector wave obtained by combining the input wave X and the orthogonal wave -Y, and the combined vector wave is the constant-amplitude wave B (= X - Y) having the constant amplitude. Thus, the signals input to the amplifiers 1 and 2 have the respective constant-amplitude waves A and B in which the envelopes thereof have the constant amplitudes. As a result, it is not necessary to form the amplifiers 1 and 2 of the linear amplifiers. In other words, the amplifiers 1 and 2 can be formed of high-efficient non-linear analog amplifiers, such as C-class amplifiers.

The amplified outputs kA and kB respectively generated by the amplifiers 1 and 2 are combined by the in-phase hybrid circuit 7. In this case, the components of the orthogonal wave Y are mutually canceled at the output terminal 73, so that the output wave 2kX which are the signal components of the input wave are obtained at the output terminal 73.

FIG.6 illustrates a variation of the amplifier shown in FIG.3. In FIG.6, those parts which are the same as those shown in the previous figures are given the same reference numerals. The variation shown in FIG.6 is different from the amplifier shown in FIG.3 in that the amplified output from the amplifier 1 is fed back to the input of the amplifier 2 via an attenuator 9 having an attenuation level 1/k and a subtracter 8, and the amplified output from the amplifier 2 is fed back to the input of the amplifier 1 via an attenuator 10 having an attenuation level 1/k and the adder 3. Further, the amplified outputs from the amplifiers 1 and 2 are input to input terminals 111 and 112, respectively, of a 180° out-of-phase hybrid circuit 11.

In the stable oscillation state, the output of the adder 3 is (Y + X), the output of the adder 8 is (Y - X) (that is, -B), the output of the amplifier 1 is k(Y + X), the output of the amplifier 2 is k(Y - X), and an output obtained at an output terminal 113 of the 180° out-of-phase hybrid circuit 11 is 2kX. Thus, the output signals from the adder 3 and the subtracter 4 have constant envelopes having equal amplitudes, so that the amplifiers 1 and 2 can be formed of non-linear analog amplifiers.

A description will now be given of a constant-amplitude wave combination type amplifier according to a further embodiment described hereinbelow for better understanding of the present invention. FIG.7 shows an outline of said further embodiment, in which those parts which are the same as those shown in the previous figures are given the same reference numerals. The amplifier shown in FIG.7 has a constant-amplitude wave generating circuit 46, two amplifiers 41 and 42, a wave combining circuit 47 and an auxiliary wave feedback circuit 48. The constant-amplitude wave generating circuit 46, which is formed of an analog circuit, combines an input wave and an auxiliary signal (also referred to as an auxiliary input signal) from the auxiliary wave feedback circuit 48, and generates two constant-amplitude waves having constant envelopes having equal amplitudes. The wave combining circuit 47 combines the outputs of the amplifiers 41 and 42, and generates an output wave and an auxiliary output wave. The auxiliary output wave is fed back to the input of the constant-amplitude wave generating circuit 46 via the auxiliary wave feedback circuit 48. It will be noted that a closed-loop circuit related to the auxiliary output wave is formed, this closed-loop circuit causing the circuit to oscillate. The outputs of the constant-amplitude wave generating circuit 46 are constant-amplitude waves when the circuit is stable in the oscillation state.

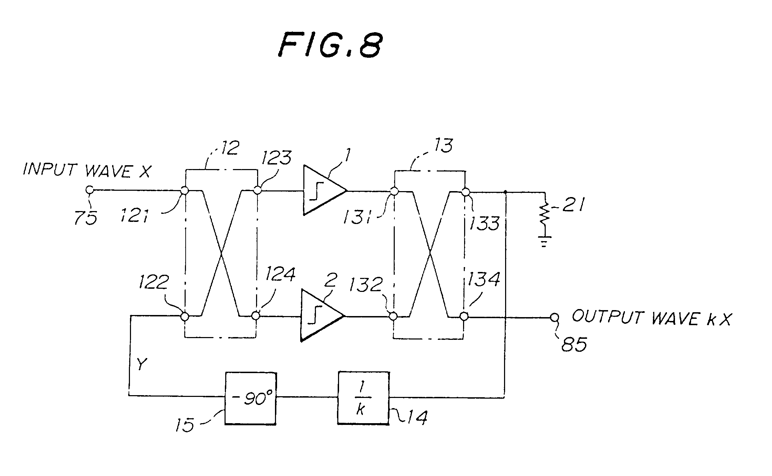

FIG.8 illustrates the configuration shown in FIG.7 in more detail. The configuration shown in FIG.8 has a 90° hybrid circuit 12 corresponding to the constant-amplitude wave generating circuit 46 (FIG.7), a 90° hybrid circuit 13 corresponding to the wave combining circuit 47, an attenuator 14 having an attenuation level 1/k, and a -90° phase shifter 15. The combination of the attenuator 14 and the 90° phase shifter 15 corresponds to the auxiliary wave feedback circuit 48 shown in FIG.7.

The input wave X is input to an input terminal 121 of the 90° hybrid circuit 12, and an auxiliary wave labeled Y is input, as a feedback signal, to an input terminal 122 of the 90° hybrid circuit 12. Output signals obtained at output terminals 123 and 124 of the 90° hybrid circuit 12 are respectively supplied to input terminals 131 and 132 of the 90° hybrid circuit 13 via the amplifiers 1 and 2, respectively. An output signal obtained at an output terminal 133 of the 90' hybrid circuit 13 is terminated via the terminating resistor 21, and fed back to the input terminal 122 of the 90° hybrid circuit via the attenuator 14 and the -90° phase shifter 15 connected in series. On the other hand, an output wave xK which is an amplified version of the input wave X is obtained at an output terminal 134 of the 90° hybrid circuit 13 connected to the output terminal 85.

The 90° hybrid circuit 12 branches each of the waves applied to the input terminals 121 and 122 thereof into two signals, and outputs in-phase components to identical direction terminals (terminals 123 and 124 with respect to the terminals 121 and 122, respectively), and 90°-phase-shifted components to cross-direction output terminals (terminals 124 and 123 with respect to the terminals 121 and 122, respectively). At each of the output terminals 123 and 124, the phase of one of the input signals input to the two input terminals 121 and 122 is shifted by 90°, and the other one of the input signals and the above phase shifted input signal are vector-combined. The 90° hybrid circuit 13 operates in the same way as the 90° hybrid circuit 12.

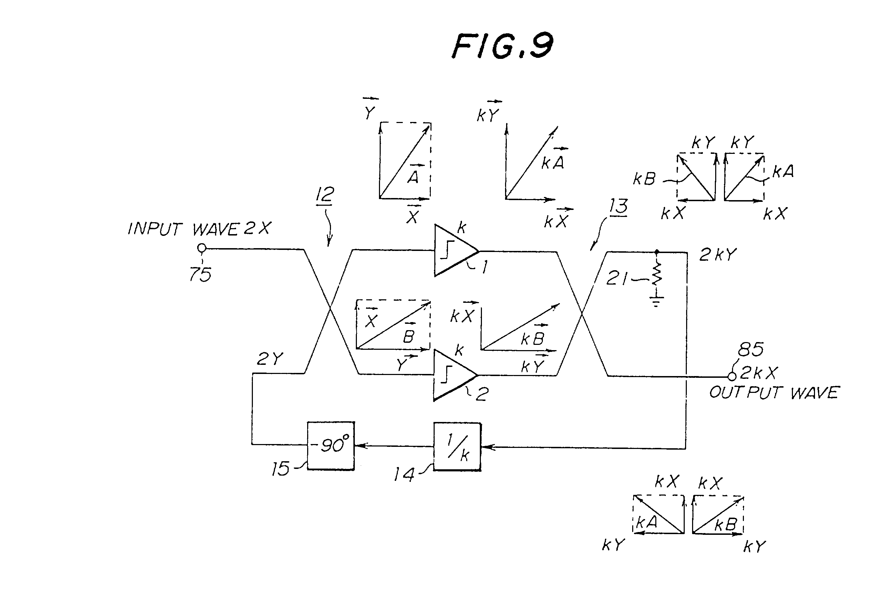

A description will now be given of the operation of the circuit shown in FIG.8 with reference to FIG.9, which shows the states of signals obtained at nodes by using vectors. The output signal obtained at the output terminal 133 of the 90° hybrid circuit 13 is fed back, as the auxiliary wave, to the input terminal 122 of the 90' hybrid circuit 12 via the attenuator 14 and the 90° phase shifter 15, so that the circuit can stably oscillate. It will be noted that the gain of the feedback circuit which carries the auxiliary wave is equal to 1 when the circuit stably oscillates.

It is assumed that the input signal having an amplitude 2X is input to the input terminal of the 90° hybrid circuit 12. On the other hand, an output wave 2kY obtained at the output terminal 133 of the 90° hybrid circuit 13 passes through the attenuator 14 and the -90' phase shifter 15, so that an auxiliary wave 2Y is fed back to the input terminal 122 of the 90' hybrid circuit 12. Since the phase of the output wave 2Y is shifted by -90' in the -90° phase shifter 15, the auxiliary wave 2Y is in phase with the input wave 2X. At the output terminal 123 of the 90° hybrid circuit 12, the input wave X and the auxiliary wave Y which has been phase-shifted by 90' are vector-combined, so that the constant-amplitude wave A is generated. At the output terminal 124 of the 90' hybrid circuit 12, a wave obtained by shifting the phase of the input wave X by 90° and the auxiliary wave Y are combined, so that the constant-amplitude wave B is generated. The constant-amplitude waves A and B have constant envelopes having equal amplitudes.

The constant-amplitude waves A and B are amplified by the amplifiers 1 and 2, respectively, so that amplified outputs kA and kB are applied to the input terminals 131 and 132 of the 90° hybrid circuit 13, respectively. The 90° hybrid circuit 13 combines the amplified outputs kA and kB. More specifically, at the output terminal 133, a wave kA/2 and a wave kB/2 which has been phase-shifted by 90° are combined, so that signal components of the input wave X are mutually canceled and signal components of the auxiliary wave Y are extracted as the auxiliary output wave 2kY. At the output terminal 134 of the 90° hybrid circuit 13, a wave kA/2 which has been phase-shifted by 90° is combined with the wave kB/2, so that the signal components of the auxiliary output wave Y are mutually canceled. As a result, the amplifiers 1 and 2 can be formed of analog circuits, so that the amplifier shown in FIG.8 can be formed of a small number of structural elements, consume a small amount of power, and operate at a high speed.

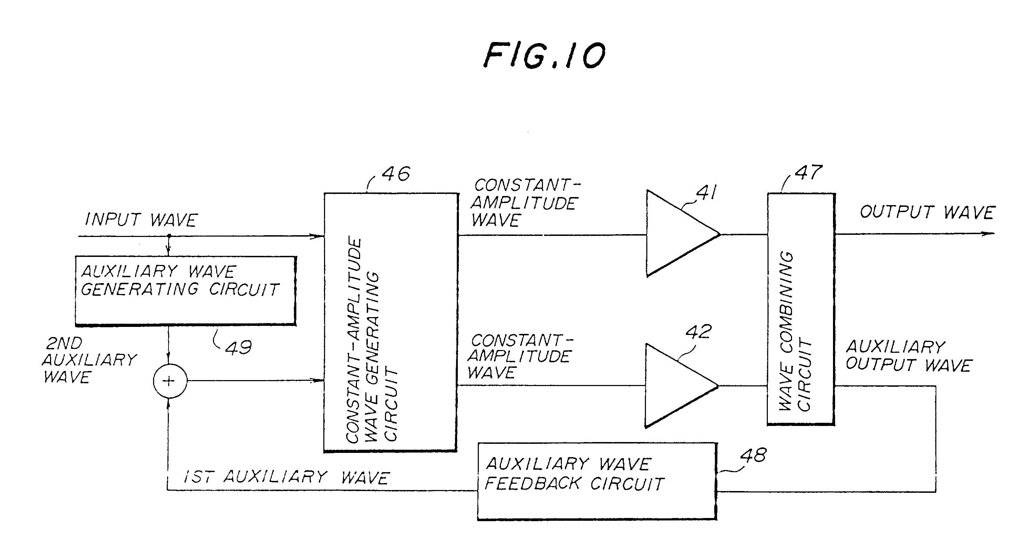

A description will now be given of a constant-amplitude wave combination type amplifier according to a first preferred embodiment of the present invention. Referring to FIG.10, there is illustrated an outline of the first preferred embodiment of the present invention. In FIG.10, those parts which are the same as those shown in the previous figures are given the same reference numerals. The configuration shown in FIG.10 is obtained by adding an auxiliary wave generating circuit 49 and an adder 17 to the configuration shown in FIG.7. The auxiliary wave generating circuit 49 generates a second auxiliary wave from the input wave. Hereafter, the auxiliary wave from the auxiliary wave feedback circuit 48 is referred to as the first auxiliary wave. The adder 17 adds the first and second auxiliary waves, and outputs an added wave to the constant-amplitude generating circuit 46.

More specifically, the auxiliary wave generating circuit 49 generates the second auxiliary wave when the amplitude of the input wave is small. With this arrangement, it becomes possible to prevent the amplifier shown in FIG.7 from being in an unstable state when the amplitude of the input wave is small.

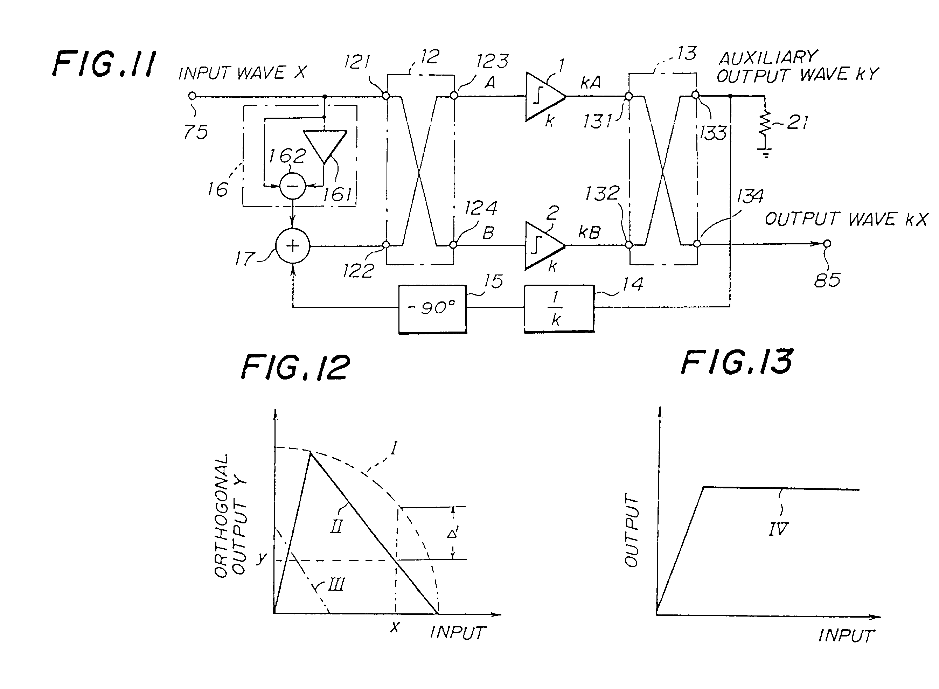

FIG.11 illustrates the configuration of the amplifier shown in FIG.10 in more detail. In FIG.11, those parts which are the same as those shown in the previous figures are given the same reference numerals. The auxiliary wave generating circuit 49 shown in FIG.10 is formed of an analog approximate solution circuit 16, which is made up of a limiter amplifier 161 and a subtracter 162. The approximate solution circuit 16 outputs an approximate solution signal (which corresponds to the aforementioned second auxiliary wave) to the input terminal 122 of the 90° hybrid circuit 12 via the adder 17. The first auxiliary wave from the auxiliary wave feedback circuit 48 is also input to the input terminal 122 via the adder 17.

The input wave X passes passes through the limiter amplifier 161 and is input to the subtracter 162, which carries out a subtraction operation on the input wave X and the output wave from the limiter amplifier 161 and outputs an approximate solution of the amplitude of the orthogonal wave Y.

As shown in FIG.12, a characteristic II approximate to a circular characteristic I is realized by the analog approximate solution circuit 16, so that the orthogonal wave Y with respect to the input wave X is approximately generated. That is, the limiter amplifier 161 has an input/output characteristic IV, as shown in FIG.13. Thus, when the output of the limiter amplifier 161 is subtracted from the input wave X by the subtracter 162, the characteristic II shown in FIG.12 is obtained. It will be noted that the approximate solution output generated by the approximate solution circuit 16 is in phase with the input wave X.

By using the approximate solution circuit 16, it becomes possible to generate the auxiliary wave Y which is to be applied to the input terminal 122 of the 90° hybrid circuit 12 when the input wave X is small. With this arrangement, the amplifier can operate stably.

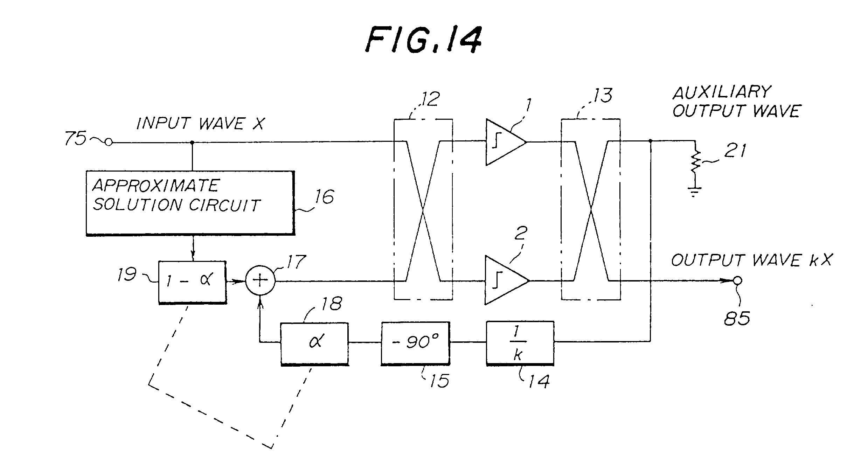

FIG.14 illustrates a variation of the configuration shown in FIG.11. In FIG.14, those parts which are the same as those shown in FIG.ll are given the same numerals. The configuration shown in FIG.14 is different from that so in FIG.11 in that the approximate solution output from the approximate solution circuit 16 is applied to the adder 17 via an attenuator 19 having an attenuation level 1 - α (α ≤ 1) and the first auxiliary wave fed back via the -90° attenuator 15 is applied to the adder 17 via an attenuator 18 having an attenuation level α. The attenuator 18 attenuates the first auxiliary wave by the attenuation level α, and the attenuator 19 attenuates the second auxiliary wave (approximate solution output) by the attenuation level (1 - α). The coefficient α is determined based on the stable oscillating state, so that the circuit shown in FIG.14 can operate more stably and a distortion of the output wave Y can be further reduced.

The second auxiliary wave generating circuit 49 shown in FIG.10 is not limited to the above-mentioned approximate solution circuit 16. For example, it is possible to form the second auxiliary wave generating circuit 49 of a circuit which has an input/output characteristic III shown in FIG.12. It should be noted that the second auxiliary wave should have a frequency equal to that of the input wave X.

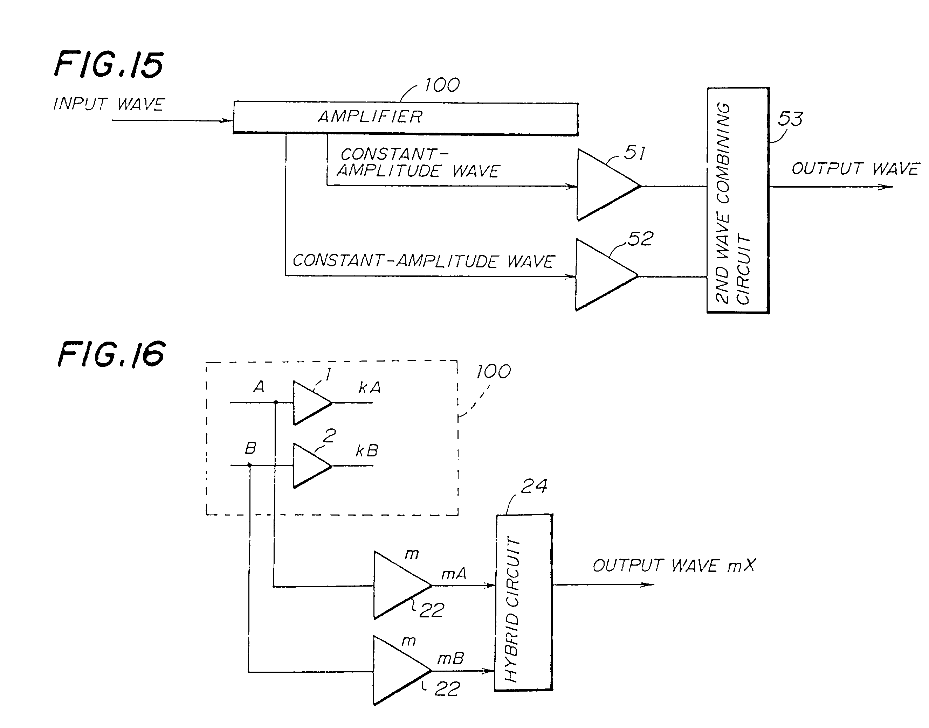

A description will now be given of a constant-amplitude wave combination type amplifier according to a second preferred embodiment of the present invention with reference to FIG.15. The amplifier shown in FIG.15 is made up of a constant-amplitude wave combination type amplifier 100, two amplifiers 51 and 52, and a second wave combining circuit 53. The constant-amplitude combination type amplifier 100 is formed of any one of the aforementioned first and second embodiments and of said first preferred embodiment of the preset invention.

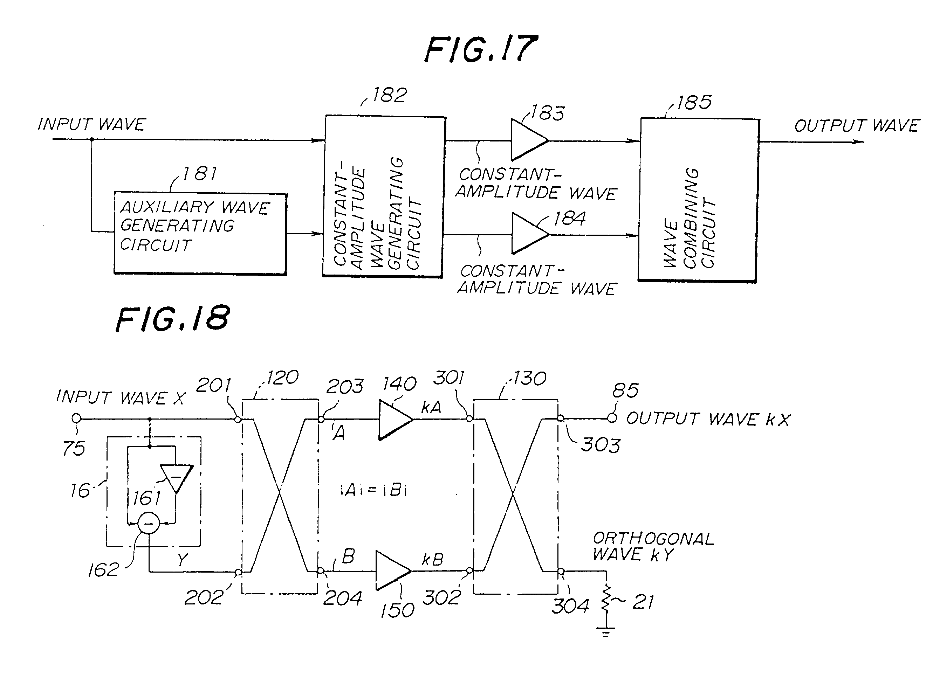

FIG.16 illustrates the configuration shown in FIG.15 in more detail. Amplifiers 22 and 23 correspond to the amplifiers 51 and 52 shown in FIG.15, respectively, and have equal amplification gains m. The amplifiers 22 and 23 receive the constant-amplitude waves A and B, and output amplified outputs mA and mB, respectively. Alternatively, the amplifiers 22 and 23 receive the constant-amplitude waves kA and kB. A hybrid circuit 24 corresponds to the second wave combining circuit 53, and outputs an output wave mX which is an amplified version of the input wave X. Since the configuration shown in FIG.16 has the amplifiers 22 and 23 separately from the amplification circuits having the feedback loop. With this arrangement, it is possible to efficiently amplify the input wave X.

A description will now be given of a constant-amplitude wave combination type amplifier according to a third preferred embodiment of the present invention with reference to FIG.17. The amplifier shown in FIG.17 has an auxiliary wave generating circuit 181, a constant-amplitude wave generating circuit 182, two amplifiers 183 and 184, and a combination circuit 185. The auxiliary wave generating circuit 181 is formed of an analog circuit which approximately generates an auxiliary wave from an input wave. The auxiliary wave is combined with the input wave by the constant-amplitude wave generating circuit 182, so that constant-amplitude waves are generated and output by the circuit 182. The amplifiers 183 and 184 amplify the corresponding constant-amplitude signals from the constant-amplitude wave generating circuit 182, and output amplified waves to the wave combining circuit 185. The wave combining circuit 185 combines to amplified waves and generates an output wave which is an amplified version of the input wave.

The auxiliary wave generating circuit 181 approximately generates the auxiliary wave orthogonal to the input wave by an analog circuit so that a combined vector wave obtained by vector-combining the input wave and the auxiliary wave has a constant amplitude. The constant-amplitude waves, which are generated from the input wave and the auxiliary wave by the constant-amplitude wave generating circuit 182, have constant envelopes having equal amplitudes. It is required that the amplifiers 183 and 184 amplify the constant-amplitude waves, and thus they are highly efficient non-linear amplifiers.

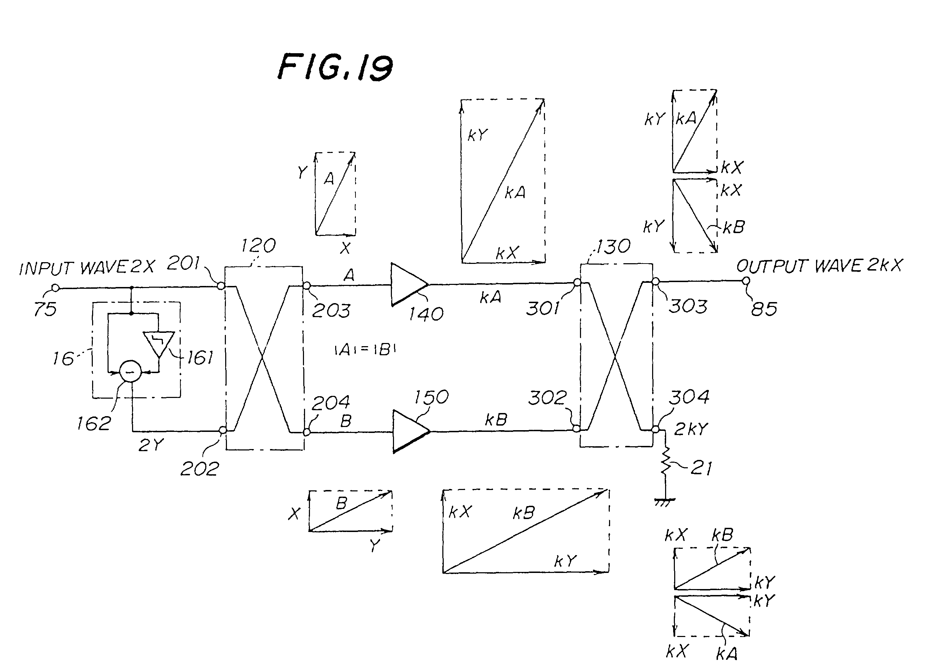

FIG.18 illustrates the configuration shown in FIG.17 in more detail. The auxiliary wave generating circuit 181 is formed of the aforementioned approximate solution circuit 16 which is made up of the limiter amplifier 161 and the subtracter 162. As has been described previously, the approximate solution circuit 16 approximately generates the amplitude of the orthogonal wave Y so that the combined vector wave obtained by combining the input wave X applied to the input terminal 7 and the auxiliary wave has a constant amplitude. The approximate solution output has the characteristic II shown in FIG.12. Since the auxiliary wave Y is in phase with the input wave X, a phase shifter means for rotating the phase of the auxiliary signal by 90° is provided at a following stage.

The auxiliary wave Y is input to an input terminal 202 of a 90' hybrid circuit 120 (which corresponds to the constant-amplitude wave generating circuit 182 shown in FIG.17). The input wave X is input to an input terminal 201 of the 90' hybrid circuit 120. The 90' hybrid circuit 120 branches each of the input waves into two waves. Then, the 90' hybrid circuit 120 outputs in-phase components to identical direction output terminals (output terminals 203 and 204 with respect to the input terminals 201 and 202, respectively), and outputs 90°-phase-shifted components to cross-direction output terminals (output terminals 204 and 203 with respect to the input terminals 201 and 202, respectively). That is, on a side of each of the output terminals 203 and 204, one of the two branched waves is shifted by 90° and combined with the other branched wave. In the above-mentioned manner, two constant-amplitude waves A and B having constant envelopes having equal amplitudes are obtained at the output terminals 203 and 204.

The constant-amplitude waves A and B pass through the amplifiers 140 and 150, which can be formed of highly efficient non-linear amplifiers, such as C-class amplifiers, and are input to input terminals 301 and 302 of a -90' hybrid circuit 130 (which corresponds to the combination amplifier 185 shown in FIG.17). The -90° hybrid circuit 130 operates in the same way as the 90' hybrid circuit 120 except that the phase rotating angle is -90°. The -90' hybrid circuit 130 outputs an output wave kX which is an amplified version of the input wave X to an output terminal 303 connected to the output terminal 8, and outputs an output wave kY which is an amplified version of the auxiliary wave Y to an output terminal 304, which wave is terminated via the resistor 21.

A description will now be given of the operation of the amplifier shown in FIG.18 with respect to FIG.19. Assuming that the amplitude of the input wave is equal to 2X, the approximate solution generating circuit 16 generates an auxiliary wave 2Y according to the characteristic II shown in FIG.12, and outputs it to the input terminal 202 of the 90' hybrid circuit 120. The 90° hybrid circuit outputs the constant-amplitude wave A obtained by combining the input wave X and a 90°-phase-shifted version of the auxiliary wave Y to the output terminal 203, and outputs the constant-amplitude wave B obtained by combining a 90°-phase-shifted version of the input wave X and the auxiliary wave Y to the output terminal 204. The amplitudes of the constant-amplitude waves and B are equal to each other, that is, |A| = |B|. The constant-amplitude waves A and B are respectively amplified by the amplifiers 140 and 150, so that amplified outputs kA and kB are generated and output by the amplifiers 140 and 150, respectively.

The -90° hybrid circuit 130 combines the amplified outputs kA and kB, and outputs the output wave 2kX obtained by the amplified output kA and a -90°-phase-shifted version of the amplified output kB to the output terminal 303, so that the orthogonal components are canceled. Further, the -90° hybrid circuit 130 outputs the output wave 2kY obtained by a -90°-phase-shifted version of the amplified output kA and the amplified output kB to the output terminal 304, so that the orthogonal components are canceled.

It will be noted that the constant-amplitude waves A and 3 can be generated by a simple analog circuit comprising the approximate solution circuit 16 and the 90° hybrid circuit 120.

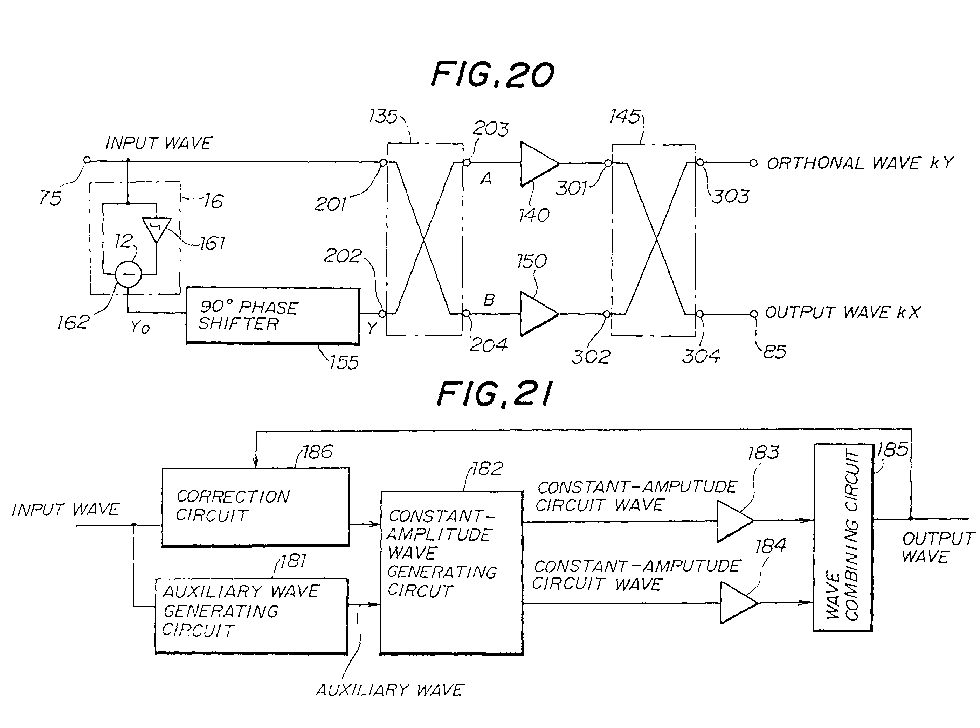

FIG.20 is a variation of the configuration shown in FIG.19. In FIG.20, those parts which are the same as those shown in FIG.19 are given the same reference numerals. A 90° phase shifter 155 is connected between the output of the approximate solution circuit 16 and the input terminal 202 of the 90° hybrid circuit 130. A in-phase (or 180°-out-of-phase) hybrid circuit 135 and a 90' hybrid circuit 145 are respectively substituted for the 90° and -90° hybrid circuits 130 and 140 shown in FIG.18. The auxiliary wave (approximate solution output) from the approximate solution circuit 16, now labeled Yo, passes through the 90' phase shifter 155, so that the auxiliary wave Y orthogonal to the input wave X can be generated and supplied to the input terminal 202 of the in-phase hybrid circuit 135. With this arrangement, it is also possible to generate the constant-amplitude waves A and B which are supplied to the amplifiers 140 and 150, respectively and obtain the output wave kX which is an amplified version of the input wave X.

A description will now be given of a constant-amplitude wave combination type amplifier according to a fourth preferred embodiment of the present invention with reference to FIG.21, in which those parts which are the same as those shown in the previous figures are given the same reference numerals.

The configuration shown in FIG.21 is obtained by adding a correction circuit 186 to the configuration shown in FIG.17. The correction circuit 186 detects a distortion component contained in the output wave generated by the wave combining circuit 185, generates a correction value which cancels the detected distortion component, and adds the correction value to the input wave. With the above arrangement, it is possible to suppress the occurrence of a distortion of the output wave.

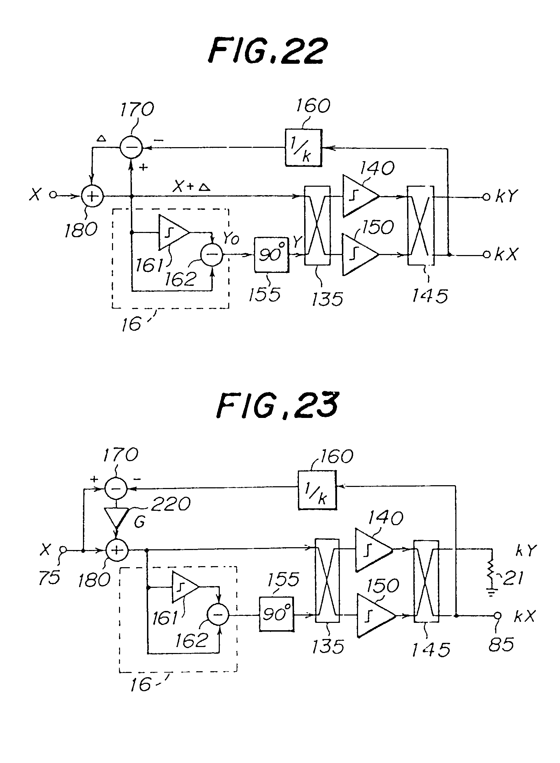

FIG.22 illustrates the configuration shown in FIG.21 in more detail. In FIG.22, those parts which are the same as those shown in FIG.20 are given the same reference numerals. The orrection circuit 1a6 shown in FIG.21 has an attenuator 160 having an attenuation level 1/k, a subtracter 170 and an adder 180. The output wave kX passes through the attenuator 160, and is applied to the subtracter 170, which also receives the input wave X which has passed through the adder 180. The subtracter 170 subtracts the signal from the attenuator 160 from the input wave X from the adder 180, and generates a distortion component Δ contained in the output wave kX. The adder 180 adds the distortion component Δ to the input wave X, and outputs a signal X + Δ to the in-phase (or 180°-out-of-phase) hybrid circuit 125.

A description will now be given of the operation of the amplifier shown in FIG.22. It is now assumed that a distortion kΔ occurs in the output wave kX due to the fact that the approximate solution circuit 16 generates the approximate solution output. The output wave containing the distortion kΔ (that is, kX + kΔ) is attenuated (multiplied) by 1/k through the attenuator 160, and applied to the subtracter 170. Then, the subtracter 170 subtracts the (X + Δ) from the input wave X and generates the distortion component Δ. The adder 180 adds the distortion component Δ to the input wave X in such a way that the distortion component Δ has a polarity which cancels the distortion component kΔ in the output wave kX. In this way, the component kΔ in the output wave kX is reduced.

FIG.23 illustrates a variation of the configuration shown in FIG.22. In FIG.23, those parts which are the same as those shown in FIG.22 are given the same reference numerals. The subtracter 170 subtracts the wave supplied from the attenuator 160 from the input wave obtained before it is input to the adder 180, and generates the distortion component Δ. An amplifier 220, which is provided between the subtracter 170 and the adder 180, amplifies the distortion component Δ so that it has an amplified amplitude sufficient to cancel the distortion kΔ contained in the output wave kX. Except the above, the operation is the same as that of the amplifier shown in FIG.22.

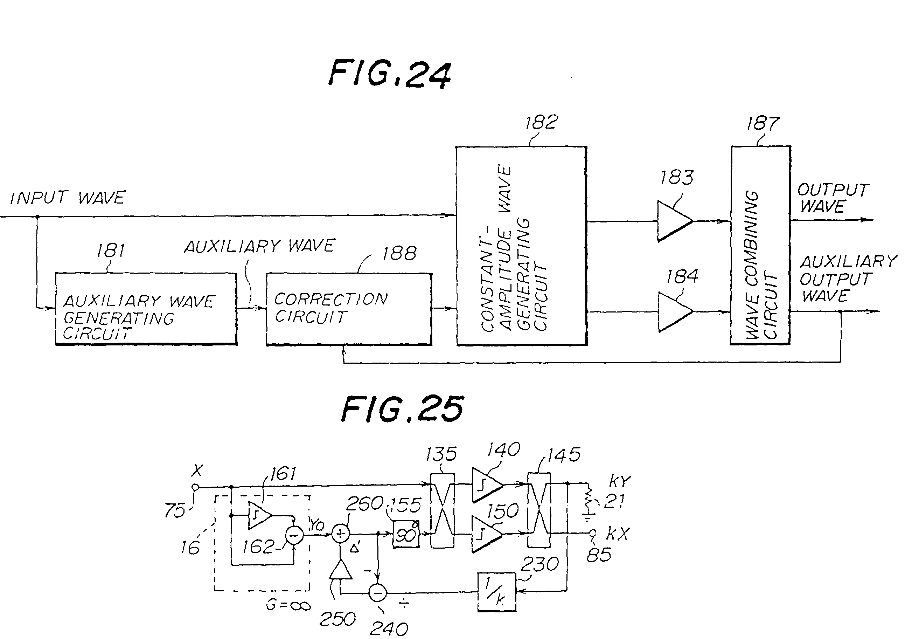

A description will now be given of a constant-amplitude wave combination type amplifier according to a fifth preferred embodiment of the present invention with reference to FIG.24, in which those parts which are the same as those shown in the previous figures are given the same referenca numerals. As shown in FIG.24, a correction circuit 188 is provided between the auxiliary wave generating circuit 181 and the constant-amplitude wave generating circuit la2. The correction circuit 188 compares the auxiliary wave with an auxiliary output wave generated by a wave combining circuit 187 to generate a distortion component contained in the output wave, and generates a correction value which cancels the distortion component in the output wave on the basis of the comparison result. The correction value is added to the auxiliary wave generated by the auxiliary wave generating circuit 181.

FIG.25 illustrates the configuration shown in FIG.24 in more detail. In FIG.25, those parts which are the same as those shown in the previous figures are given the same reference numerals. The correction circuit 188 shown in FIG.24 is made up of an attenuator 230 having an attenuation level 1/k, a subtracter 240, an amplifier 250 and an adder 260. The auxiliary output wave kY generated by the hybrid circuit 145 is attenuated (multiplied) by 1/k, and applied to the subtracter 240. The subtracter 240 subtracts an output of the adder 260 from the output from the attenuator 230, and outputs a difference signal to the adder 260 via the amplifier 250. The difference signal having an amplified signal serves as a correction value Δ indicative of a distortion component contained in the output wave kX. The adder 260 adds the correction value Δ and the auxiliary wave generated and output by the approximate solution circuit 16, now labaled Yo, and outputs an addition result to the hybrid circuit 135 through the 90' phase shifter 155.

The magnitude of the correction value Δ is adjusted so that as shown in FIG.12, it is equal to a deviation Δ' between the input/output characteristic II of the approximate solution circuit 16 and the ideal circular characteristic I. The input/output characteristic of the approximate solution circuit 16 including the correction circuit 188 is corrected by adding the correction value Δ' to the auxiliary wave Yo, so that it approximately has the circular characteristic. With this arrangement, it becomes possible to generate the constant-amplitude waves A and B to definitely have the constant amplitudes and thus reduce the distortion in the auxiliary output wave kY. It will be noted that when the distortion in the auxiliary output wave kY is reduced, the distortion in the output wave xK is also reduced.

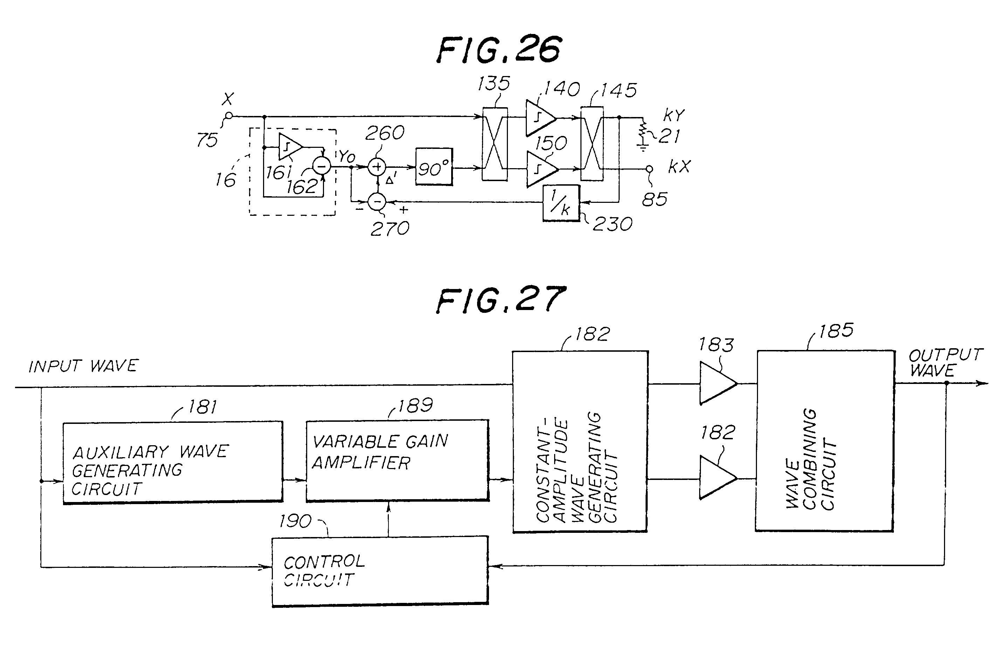

FIG.26 illustrates a variation of the configuration shown in FIG.25. In FIG.26, those parts which are the same as those shown in FIG.25 are given the same reference numerals. The variation shown in FIG.26 is different from the amplifier shown in FIG.25 in that a subtracter 270 calculates the difference (correction value) Δ' between the signal from the attenuator 230 and the auxiliary wave Yo from the approximate solution circuit 16, and the adder 260 adds the correction values Δ' to the auxiliary wave Yo. Except for the above operation, the operation of the amplifier shown in FIG.26 is the same as that of the amplifier shown in FIG.25.

A description will now be given of a constant-amplitude wave combination type amplifier according to an sixth preferred embodiment of the present invention with reference to FIG.27, in which those parts which are the same as those shown in the previous figures are given the same reference numerals. As shown in FIG.27, a variable gain amplifier 189 is provided between the auxiliary wave generating circuit 181 and the constant-amplitude wave generating circuit 182. A control circuit 190 compares the input wave with the output wave to detect a distortion component in the output wave output by the wave combining circuit 185, and controls the gain of the variable gain amplifier 189 so that the detected distortion component is canceled.

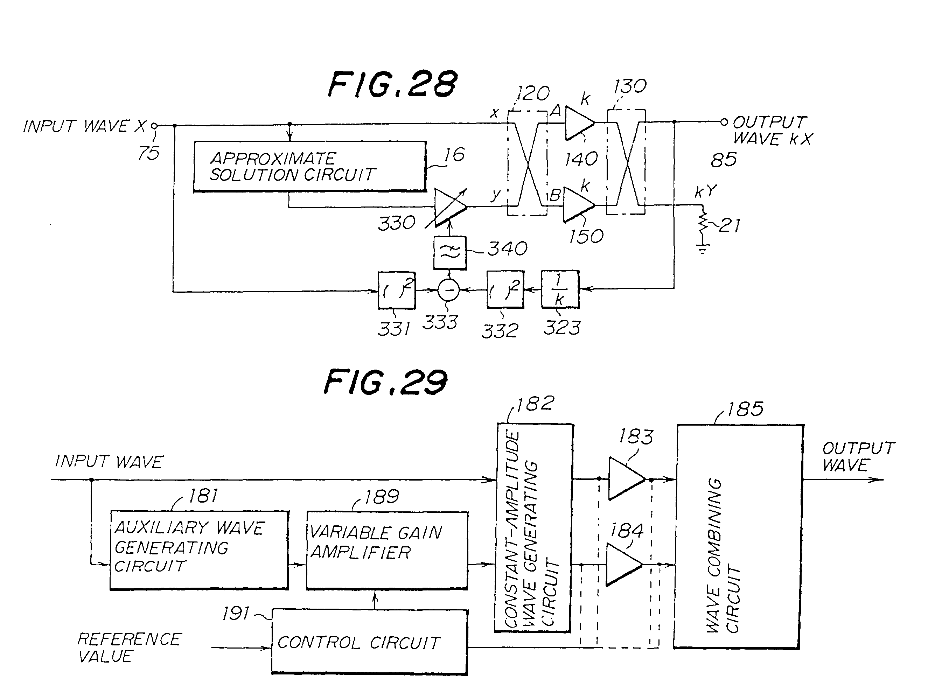

FIG.28 illustrates the configuration of the amplifier shown in FIG.27 in more detail. In FIG.28, those parts which are the same as those shown in the previous figures are given the same reference numerals. The variable gain amplifier 189 is formed of an AGC amplifier 340. The control circuit 190 shown in FIG.27 has square-law circuits 331 and 332, an attenuator having an attenuation level l/k, a subtracter 333, and a lowpass filter 340.

The output wave kX from the -90° hybrid circuit 130 is attenuated (multiplexed) by the attenuation level 1/k. The square-law circuit 332 squares the wave from the attenuator 323, and outputs a squared output to the subtracter 333. On the other hand, the input wave X is squared by the square-law circuit 331, and applied to the subtracter 333. The subtracter 333 calculates the difference Δ between the outputs of the square-law circuits 331 and 332. A signal indicative of the difference Δ passes through the lowpass filter 340, so that a D.C. component of the signal is applied, as a gain control voltage, to the AGO amplifier 330. The AGC amplifier 330 amplifies the approximate solution output from the approximate solution circuit 16 by the gain designated by the gain control voltage, so that the linear relationship between the input wave X and the output wave Y can be obtained.

When the auxiliary wave (approximate solution output) Y generated by the approximate solution circuit 16 has the ideal circular characteristic I shown in FIG.12, the output wave kY generated and output by the hybrid circuit 130 does not have any distortion theoretically. However, generally, a distortion component will be contained in the output wave kX. The distortion component contained in the output wave kX is extracted by the subtracter 333, and the gain of the AGO amplifier 330 is controlled so that the detected distortion component becomes zero. With this control, it becomes possible for the auxiliary wave Y to approximately have the circular characteristic I shown in FIG.12.

FIG.29 illustrates a constant-amplitude wave combination type amplifier according to a seventh embodiment of the present invention. In FIG.29, those parts which are the same as those shown in FIG.27 are given the same reference numerals. A control circuit 191 is substituted for the control circuit 190 shown in FIG.27. The control circuit 191 compares one of the constant-amplitude waves generated by the constant amplitude wave generating circuit 182 or the amplified versions thereof obtained from the amplifiers 183 and 184 with a predetermined reference value, and controls the gain of the variable gain amplifier 189 on the basis of the comparison result so that the constant-amplitude waves have constant amplitudes.

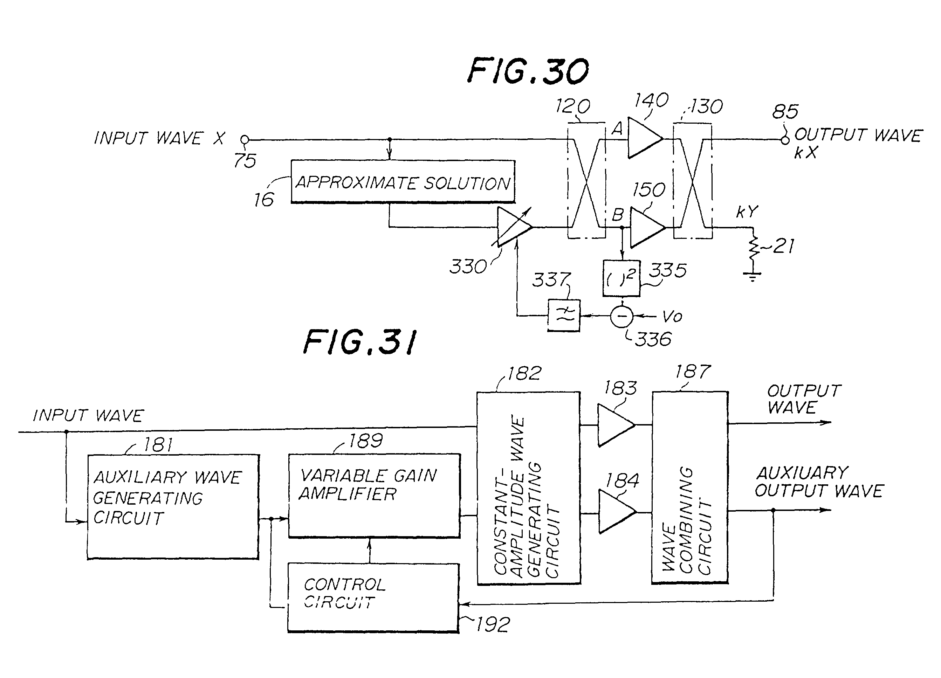

FIG.30 illustrates the configuration shown in FIG.29 in more detail. In FIG.30, those parts which are the same as those shown in FIG.28 are given the same reference numerals. The control circuit 191 shown in FIG.29 is made up of a square-law circuit 335, a subtracter 336 and a lowpass filter 337. The constant-amplitude wave B generated by the hybrid circuit 120 is squared by the square-law circuit 335, and a squared value is applied to the subtracter 336. The subtracter 336 calculates the difference between the squared value from the square-law circuit 335 and a predetermined reference value Vo. A signal indicative of the above difference passes through the lowpass filter 337, so that a D.C. component contained in the output of the lowpass filter is applied, as the gain control signal, to the AGC amplifier 330. The gain of the AGC amplifier 330 is controlled so that the difference calculated by the subtracter 336 becomes zero.

When the input/output characteristic of the approximate solution circuit 16 corresponds to the ideal circular characteristic I shown in FIG.12, the constant-amplitude waves A and B generated by the constant-amplitude wave generating circuit 120 have definitely constant envelope amplitudes. On the other hand, when the input/output characteristic of the approximate solution circuit 16 corresponds to the approximate characteristic II shown in FIG.12, the amplitudes of the constant-amplitude waves A and B have slight variations. The configuration shown in FIG.30 is based on the above-mentioned fact. By controlling the gain of the AGC amplifier 330 so that the difference calculated by the subtracter 336 becomes zero, the auxiliary wave generated by the approximate solution circuit 16 has the ideal characteristic I shown in FIG.12.

FIG.31 shows a constant-amplitude wave combination type amplifier according to an eighth preferred embodiment of the present invention. In FIG.31, those parts which are the same as those shown in FIG.27 are given the same reference numerals. A control circuit 192 is substituted for the control circuit 190 shown in FIG.27. The control circuit 192 compares the output of an auxiliary output wave generated by the wave combining circuit 187 with the auxiliary wave generated by the auxiliary wave generating circuit 181 to detect a distortion component contained in the auxiliary output wave, and controls the gain of the variable gain amplifier 189 so that the distortion component in the auxiliary output wave is canceled.

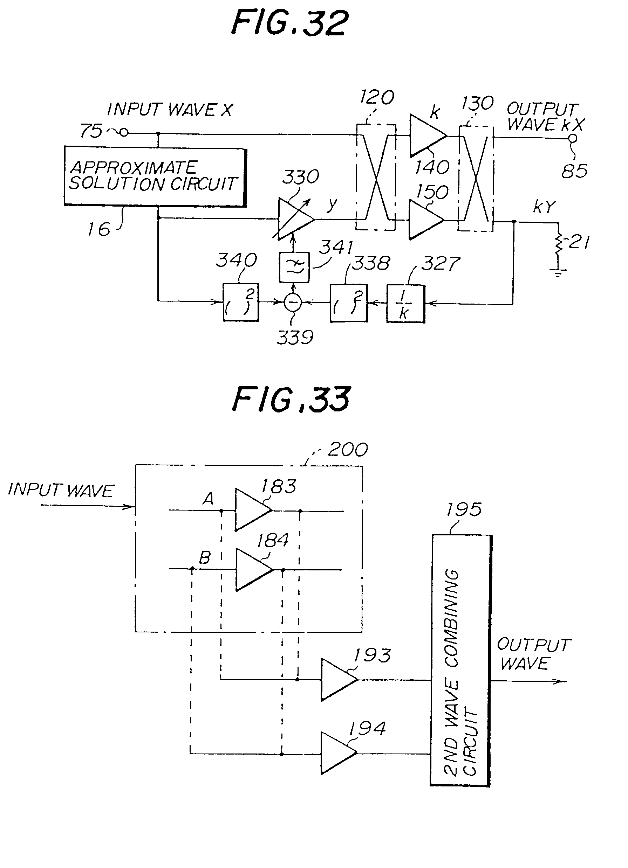

FIG.32 illustrates the configuration shown in FIG.31 in more detail. In FIG.32, those parts which are the same as those shown in FIG.30 are given the same reference numerals. The control circuit 192 shown in FIG.31 has an attenuator 327 having an attenuation level 1/k, two square-law circuits 338 and 340, a subtracter 339 and a lowpass filter 341. The configuration shown in FIG.32 differs from that shown in FIG.28 in that the square-law circuit 340 receives the auxiliary wave from the approximate solution circuit 16, and the attenuator 327 receives the auxiliary output wave kY generated by the wave combining circuit 130.

The auxiliary output wave kY passes through the attenuator 327 and the square-law circuit 338, and is then applied to the subtracter 339. On the other hand, the auxiliary wave from the approximate solution circuit 16 passes through the square-law circuit 340, and is then applied to the subtracter 339. The subtracter 339 calculates the difference between the outputs of the square-law circuits 328 and 340. A signal indicative of the difference passes through the lowpass filter 341, so that a D.C. component contained in the signal from the subtracter 339 is applied, as the gain control signal, to the AGC amplifier 130. With the above-mentioned arrangement, the auxiliary wave from the approximate solution circuit 16 approximately has the circular characteristic I shown in FIG.12.

FIG.33 illustrates a constant-amplitude wave combination type amplifier according to an ninth embodiment of the present invention. The amplifier shown In FIG.33 has an amplifier which is any one of the aforementioned fifth through tenth embodiments of the present invention, two amplifiers 193 and 194, and a second wave combining circuit 195 (it will be noted that the "first" combination circuit is contained in the amplifier 200). The amplifier 193 amplifies the constant-amplitude wave A or its amplified version, and the amplifier 194 amplifies the constant-amplitude wave B or its amplified version. Amplified outputs of the amplifiers 193 and 194 are combined by the second wave combining circuit 195, so that an output wave is generated.

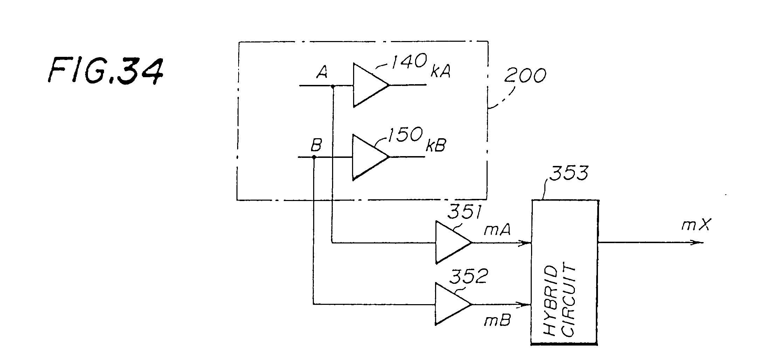

FIG.34 illustrates the configuration shown in FIG.33 in more detail. The constant-amplitude waves A and B are amplified by amplifiers 351 and 352, which output amplified constant-amplitude waves mA and mB, respectively, where m is the respective gains of the amplifiers 351 and 352. Alternatively, it is also possible to design the configuration shown in FIG.34 so that the amplifiers 351 and 352 amplify the amplified constant-amplitude waves kA and kB, respectively. A hybrid circuit 353 combines the waves mA and mB and generates an output wave mX which is an amplified version of the input wave X.

## Claims

1. A constant-amplitude wave combination type amplifier, comprising
constant-amplitude wave generating means (46; 182) for combining an input wave (X) and an auxiliary input wave (Y) and for generating a first constant-amplitude wave (A) and a second constant-amplitude wave (B);
a first amplifier (41; 183) amplifying said first constant-amplitude wave and outputting a first amplified output (kA);
a second amplifier (42; 184) amplifying said second constant-amplitude wave and outputting a second amplified output (kB);
wave combining means (47; 185; 187) coupled to said first and second amplifiers, for combining said first and second amplified outputs and for generating an output wave (kX); and
auxiliary wave generating means (49; 181) coupled to said constant-amplitude wave generating means and generating an auxiliary wave from said input wave, for forming said auxiliary input wave as a wave being orthogonal to said input wave.

2. The constant-amplitude wave combination type amplifier as claimed in claim 1, wherein said constant-amplitude wave generating means (46; 182) comprises a first 90° hybrid circuit (12; 120; 135) having a first input terminal receiving said input wave, a second input terminal receiving said auxiliary input wave, a first output terminal outputting said first constant-amplitude wave to said first amplifier, and a second output terminal outputting said second constant-amplitude wave to said second amplifier.

3. The constant-amplitude wave combination type amplifier as claimed in claim 1 or 2, wherein said wave combining means (47; 185; 187) comprises a second 90° hybrid circuit (13; 130; 145) having a first input terminal receiving said first amplified output, and a second input terminal receiving said second amplified output.

4. The constant-amplitude wave combination type amplifier as claimed in claim 3, wherein said second 90° hybrid circuit (13; 130; 145) has a first output terminal outputting said output wave, and a second output terminal which is terminated via a resistor (21).

5. The constant-amplitude wave combination type amplifier as claimed in any of the preceding claims, wherein said auxiliary wave generating means (means (49; 181) comprises
approximate solution circuit means (16) for generating an approximate solution indicative of an amplitude of an orthogonal wave (Y) orthogonal to said input wave (X),
wherein said approximate solution corresponds to said auxiliary wave generated by said auxiliary wave generating means.

6. The constant-amplitude wave combination type amplifier as claimed in any of the preceding claims, wherein said auxiliary wave generating means (49; 181) comprises
a limiter amplifier (161) which amplifies said input wave and outputs an amplitude-limited wave; and
a substracter (162) which outputs a difference between said input wave and said amplitude-limited wave, said difference corresponding to said auxiliary input wave formed by said auxiliary wave generating means.

7. The constant-amplitude wave combination type amplifier as claimed in claim 1, further comprising
auxiliary wave feedback means (48) coupled to said wave combining means (47) and said constant-amplitude wave generating means (46) and feeding back said auxiliary output wave as a further auxiliary wave; and
adder means (17) coupled to said auxiliary wave generating means (49) and said auxiliary wave feedback means (48), for adding said auxiliary wave supplied from said auxiliary wave generating means (49) and said further auxiliary wave supplied from said auxiliary wave feedback means (48) so as to form said auxiliary input wave supplied to said constant-amplitude wave generating means (46).

8. The constant-amplitude wave combination type amplifier as claimed in claim 7, wherein said auxiliary wave feedback means comprises an attenuator (14; 230; 323; 327) which attenuates said further auxiliary wave by a predetermined level (1/k).

9. The constant-amplitude wave combination type amplifier as claimed in claim 8, wherein said auxiliary wave feedback means comparises a phase shifter (15) which shifts the phase of a wave from said attenuator (14) by a predetermined angle and which outputs said further auxiliary wave.

10. The constant-amplitude wave combination type amplifier as claimed in claims 5 to 9, wherein
the output of said approximate solution circuit means (16) is attenuated by a first attenuator (19) to an attenutation level (1 - α) for being output to said adder means (17);
said attenuator (14) of said feed back means forms a second attenuator; and
said auxiliary wave feedback means (48) comprises a third attenuator (19) of an attenuation level (α), connected to said adder means (17) ;
wherein the sum of the attenuation level of said first attenuator (19) and of the attenuation level of said third attenuator (18) is equal to 1.

11. A constant-amplitude wave combination type amplifier as claimed in claim 1, wherein said auxiliary wave generating means (181) comprises:
a limiter amplifier (161) which amplifies said input wave and outputs an amplitude-limited wave; and
a substracter (162) which outputs a difference between said input wave and said amplitude-limited wave, said difference corresponding to said auxiliary input wave generated by said auxiliary wave generating means,
wherein said constant-amplitude wave generating means (182) comprises a 90° hybrid circuit (120) having a first input terminal receiving said input wave, a second input terminal receiving said auxiliary input wave, a first output terminal outputting said first constant-amplitude wave, and a second output terminal outputting said second constant-amplitude wave, and
wherein said first wave combining means (185) comprises a -90° hybrid circuit (130) having a first input terminal receiving said first amplified output, a second input terminal receiving said second amplified output, a first output terminal outputting said output wave, and a second output terminal which is terminated via a resistor (21).

12. A constant-amplitude wave combination type amplifier as claimed in claim 1, wherein said auxiliary wave generating means (181) comprises:
a limiter amplifier (161) which amplifies said input wave and outputs an amplitude-limited wave; and
a substracter (162) which outputs a difference between said input wave and said amplitude-limited wave, said difference corresponding to said auxiliary input wave generated by said auxiliary wave generating means,
wherein said constant-amplitude wave combination type amplifier further comprises a 90° phase shifter (155) which shifts a phase of said auxiliary input wave by 90° and which outputs said auxiliary input wave having a 90°-shifted phase to said constant-amplitude wave generating means (182),
wherein said constant-amplitude wave generating means (182) comprises an in-phase hybrid circuit (135) having a first input terminal receiving said input wave, a second input terminal receiving said auxiliary input wave from said 90° phase shifter, a first output terminal outputting said first constant-amplitude wave, and a second output terminal outputting said second constant-amplitude wave, and
wherein said first wave combining means (185) comprises a 90° hybrid circuit (145) having a first input terminal receiving said first amplified output, a second input terminal receiving said second amplified output, a first output terminal outputting said output wave, and a second output terminal which outputs said auxiliary output wave.

13. A constant-amplitude wave combination type amplifier as claimed in any of the preceding claims, comprising orrection means (186) for generating a correction value (Δ) indicative of a distortion component contained in the output wave of said wave-combining circuit (185) by comparing the input wave with said output wave and for adding said correction value to said input value so that said distortion component contained in said output wave is cancelled.

14. A constant-amplitude wave combination type amplifier as claimed in claim 13, wherein said correction means (186) comprises:
an attenuator (160) which attenuates said output wave by a predetermined attenuation level (1/k) and which outputs an attenuated output wave;
a substracter (170) which outputs a difference signal indicative of a difference (Δ) between said attenuated output wave and a corrected input wave; and
an adder (180) which adds said difference signal and said input wave and which outputs a corrected input wave corresponding to an addition result, said corrected input wave being supplied, as said input wave, to said constant-amplitude wave generating means, and said difference signal corresponding to said correction value.

15. A constant-amplitude wave combination type amplifier as claimed in claim 13, wherein said correction means (186) comprises:
an attenuator (160) which attenuates said output wave by a predetermined attenuation level (1/k) and which outputs an attenuated output wave;
a substracter (170) which outputs a difference signal indicative of a difference between said attenuated output wave and said input wave;
a limiter amplifier (220) which amplifies said difference signal and which outputs an amplified difference signal corresponding to said correction value; and
an adder (180) which adds said amplified difference signal and said input wave and which outputs said input wave having said amplified difference to said constant-amplitude wave generating means.

16. A constant-amplitude wave combination type amplifier as claimed in any of the preceding claims, comprising correction means (188), provided between said auxiliary wave generating means (181) and said constant-amplitude wave generating means (182), for generating a correction value (Δ') indicative of a distortion component contained in an output wave of said wave-combining circuit (187) by comparing said output wave with said auxiliary input wave and for adding said correction value to said auxiliary input wave, so that said auxiliary input wave to which said correction value has been added is supplied to said constant-amplitude wave generating means (182), and said distortion component contained in said output wave is cancelled.

17. A constant-amplitude wave combination type amplifier as claimed in claim 16, wherein said correction means (188) comprises:
an attenuator (230) which attenuates said auxiliary output wave by a predetermined attenuation level (1/k) and which outputs an attenuated auxiliary output wave;
a substracter (240) which outputs a difference signal indicative of a difference (Δ') between said attenuated auxiliary output wave and a corrected input wave;
a limiter amplifier (250) which amplifies said difference signal and which outputs an amplitude-limited difference signal corresponding to said correction value; and
an adder (260) which adds said auxiliary input wave and said amplitude-limited difference signal and which outputs said corrected input wave to said constant-amplitude wave generating means as said input wave.

18. A constant-amplitude wave combination type amplifier as claimed in claim 16, wherein said correction means (188) comprises:
an attenuator (230) which attenuates said auxiliary output wave by a predetermined attenuation level (1/k) and which outputs an attenuated auxiliary output wave;
a substracter (270) which outputs a difference signal indicative of a difference (Δ') between said attenuated auxiliary output wave and said auxiliary input wave, said difference signal corresponding to said correction value; and
an adder (260) which adds said difference signal and said auxiliary input wave and which outputs said input wave having said difference to said constant-amplitude wave generating means.

19. A constant-amplitude wave combination type amplifier as claimed in any of the preceding claims, comprising
variable gain amplifier means (189), provided between said auxiliary wave generating means (181) and said constant-amplitude wave generating means (182), for amplifying said auxiliary input wave by a gain and for outputting said auxiliary input wave having an amplified amplitude to said constant-amplitude wave generating means (182); and
control means (190) for generating a correction value indicative of a distortion component contained in an output wave of said wave-combining circuit (185) by comparing said output wave with said input wave and for controlling the gain of said variable gain amplifier means (189) on the basis of said correction value so that said distortion component contained in said output wave is cancelled.

20. A constant-amplitude wave combination type amplifier as claimed in claim 19, wherein said control means (190) comprises:
an attenuator (323) which attenuates said output wave by a predetermined attenuation level and which outputs an attenuated output wave;
a first square-law circuit (332) which squares said attenuated output wave and which outputs a squared attenuated output wave;
a second square-law circuit (331) which squares said input wave and which outputs a squared input wave;
a substracter (333) which outputs a difference signal indicative of a difference between said squared attenuated output wave and said squared input wave; and
a filter (340) which extracts a D.C. component from said difference signal and which outputs said D.C. component to said variable gain amplifier means (189), and
wherein said variable gain amplifier means (189) comprises an automatic gain control amplifier (330) having a variable gain controlled by said D.C. component.

21. A constant-amplitude wave combination type amplifier as claimed in any of the preceding claims, comprising
variable gain amplifier means (189), provided between said auxiliary wave generating means (181) and said constant-amplitude wave generating means (182), for amplifying said auxiliary input wave by a gain and for outputting said auxiliary input wave having an amplified amplitude to said constant-amplitude wave generating means (182); and
control means (192) for generating a correction value indicative of a distortion component contained in an output wave of said wave-combining circuit (185) by comparing said output wave with said auxiliary input wave and for controlling the gain of said variable gain amplifier means (189) on the basis of said correction value so that said distortion component contained in said output wave is cancelled.

22. A constant-amplitude wave combination type amplifier as claimed in claim 21, characterized in that said control means (192) comprises:
an attenuator (327) which attenuates said output wave by a predetermined attenuation level (1/k) and which outputs an attenuated output wave;
a first square-law circuit (338) which square said attenuated output wave and which outputs a squared attenuated output wave;
a second square-law circuit (340) which squares said input wave and which outputs a squared auxiliary input wave;
a subtracter (339) which outputs a difference signal indicative of a difference between said squared attenuated output wave and said squared auxiliary input wave; and
a filter (341) which extracts a D.C. component from said difference signal and which outputs said D.C. component to said variable gain amplifier means (189), and
wherein said variable gain amplifier means (189) comprises an automatic gain control amplifier (330) having a variable gain controlled by said D.C. component.

23. A constant-amplitude wave combination type amplifier as claimed in any of the preceding claims, comprising
variable gain amplifier eans (189), provided between said auxiliary wave generating means (181) and said constant-amplitude wave generating means (182), for amplifying said auxiliary input wave by a gain and for outputting said auxiliary input wave having an amplified amplitude to said constant-amplitude wave generating means (182); and
control means (191) for generating a correction value indicative of a distortion component contained in an output wave of said wave-combining circuit (185) by comparing one of said first and second constant-amplitude waves output by said constant-wave generating means (182) and said first and second amplified outputs thereof with a predetermined reference value (Vo) and for controlling the gain of said variable gain amplifier means (189) so that said distortion component contained in said output wave is cancelled.

24. A constant-amplitude wave combination type amplifier as claimed in claim 23, characterized in that said control means (191) comprises:
a square-law circuit (335) which squares said one of said first and second constant-amplitude waves and said first and second amplified outputs and which outputs a squared signal;
a substracter (336) which outputs a difference signal indicative of a difference between said squared signal and said predetermined reference value (Vo); and
a filter (337) which extracts a D.C. component from said difference signal and which outputs said D.C. component to said variable gain amplifier means (189), and
wherein said variable gain amplifier means (189) comprises an automatic gain control amplifier (330) having a variable gain controlled by said D.C. component.

25. A constant-amplitude wave combination type amplifier as claimed in any of the preceding claims, further comprising:
a third amplifier (22; 51; 193; 351) amplifying one of said first constant-amplitude wave (A) and said first amplified output (kA) and generating a third amplified output (mA);
a fourth amplifier (23; 52; 194; 352) amplifying one of said second constant-amplitude wave (B) and said second amplified output (kB) and generating a fourth amplified output (mB); and
second wave combining means (24, 53; 105; 353) coupled to said third and fourth amplifiers, for combining said third and fourth amplified outputs and for generating an output wave (mX) which is different from said output wave (kX) generated by said first wave combining means.

## Patentansprüche

1. Verstärker vom Konstantamplitudenwellen-Kombinationstyp, der folgendes aufweist:
eine Konstantamplitudenwellen-Erzeugungseinrichtung (46; 182) zum Kombinieren einer Eingangswelle (X) und einer Hilfs-Eingangswelle (Y) und zum Erzeugen einer ersten Konstantamplitudenwelle (A) und einer zweiten Konstantamplitudenwelle (B);
einen ersten Verstärker (41; 183), der die erste Konstantamplitudenwelle verstärkt und eine erste verstärkte Ausgabe (kA) ausgibt;
einen zweiten Verstärker (42; 184), der die zweite Konstantamplitudenwelle verstärkt und eine zweite verstärkte Ausgabe (kB) ausgibt;
eine Wellenkombinationseinrichtung (47; 185; 187), die mit dem ersten und dem zweiten Verstärker gekoppelt ist, zum Kombinieren der ersten und der zweiten verstärkten Ausgaben und zum Erzeugen einer Ausgangswelle (kX); und
eine Hilfswellen-Erzeugungseinrichtung (49; 181), die mit der Konstantamplitudenwellen-Erzeugungseinrichtung gekoppelt ist und eine Hilfswelle aus der Eingangswelle erzeugt, zum Ausbilden der Hilfs-Eingangswelle als eine Welle, die orthogonal zur Eingangswelle ist.

2. Verstärker vom Konstantamplitudenwellen-Kombinationstyp nach Anspruch 1, wobei die Konstantamplitudenwellen-Erzeugungseinrichtung (46; 182) folgendes aufweist: eine erste 90°-Hybridschaltung (12; 120; 135) mit einem ersten Eingangsanschluß, der die Eingangswelle empfängt, einem zweiten Eingangsanschluß, der die Hilfs-Eingangswelle empfängt, einem ersten Ausgangsanschluß, der die erste Konstantamplitudenwelle zum ersten Verstärker ausgibt, und einem zweiten Ausgangsanschluß, der die zweite Konstantamplitudenwelle zum zweiten Verstärker ausgibt.

3. Verstärker vom Konstantamplitudenwellen-Kombinationstyp nach Anspruch 1 oder 2, wobei die Wellenkombinationseinrichtung (47; 185; 187) folgendes aufweist: eine zweite 90°-Hybridschaltung (13; 130; 145) mit einem ersten Eingangsanschluß, der die erste verstärkte Ausgabe empfängt, und einem zweiten Eingangsanschluß, der die zweite verstärkte Ausgabe empfängt.

4. Verstärker vom Konstantamplitudenwellen-Kombinationstyp nach Anspruch 3, wobei die zweite 90°-Hybridschaltung (13; 130; 145) einen ersten Ausgangsanschluß hat, der die Ausgangswelle ausgibt, und einen zweiten Ausgangsanschluß, der über einen Widerstand (21) abgeschlossen ist.

5. Verstärker vom Konstantamplitudenwellen-Kombinationstyp nach einem der vorangehenden Ansprüche, wobei die Hilfswellen-Erzeugungseinrichtung (49; 181) folgendes aufweist:
eine Näherungslösungsschaltungseinrichtung (16) zum Erzeugen einer Näherungslösung, die eine Amplitude einer orthogonalen Welle (Y) orthogonal zur Eingangswelle (X) anzeigt,
wobei die Näherungslösung der durch die Hilfswellen-Erzeugungseinrichtung erzeugten Hilfswelle entspricht.

6. Verstärker vom Konstantamplitudenwellen-Kombinationstyp nach einem der vorangehenden Ansprüche, wobei die Hilfswellen-Erzeugungseinrichtung (49; 181) folgendes aufweist:
einen Begrenzerschaltungsverstärker (161), der die Eingangswelle verstärkt und eine amplitudenbegrenzte Welle ausgibt; und
einen Subtrahierer (162), der eine Differenz zwischen der Eingangswelle und der amplitudenbegrenzten Welle ausgibt, wobei die Differenz der durch die Hilfswellen-Erzeugungseinrichtung ausgebildeten Hilfs-Eingangswelle entspricht.

7. Verstärker vom Konstantamplitudenwellen-Kombinationstyp nach Anspruch 1, der weiterhin folgendes aufweist:
eine Hilfswellen-Rückkoppeleinrichtung (48), die mit der Wellenkombinationseinrichtung (47) und der Konstantamplitudenwellen-Erzeugungseinrichtung (46) gekoppelt ist und die Hilfs-Ausgangswelle als weitere Hilfswelle rückkoppelt; und
eine Addierereinrichtung (17), die mit der Hilfswellen-Erzeugungseinrichtung (49) und der Hilfswellen-Rückkoppeleinrichtung (48) gekoppelt ist, zum Addieren der von der Hilfswellen-Erzeugungseinrichtung (49) zugeführten Hilfswelle und der von der Hilfswellen-Rückkoppeleinrichtung (48) zugeführten weiteren Hilfswelle, um die zur Konstantamplitudenwellen-Erzeugungseinrichtung (46) zugeführte Hilfs-Eingangswelle auszubilden.

8. Verstärker vom Konstantamplitudenwellen-Kombinationstyp nach Anspruch 7, wobei die Hilfswellen-Rückkoppeleinrichtung ein Dämpfungsglied (14; 230; 323; 327) aufweist, daß die weitere Hilfswelle um einen vorbestimmten Pegel (1/k) dämpft.

9. Verstärker vom Konstantamplitudenwellen-Kombinationstyp nach Anspruch 8, wobei die Hilfswellen-Rückkoppeleinrichtung einen Phasenschieber (15) aufweist, der die Phase einer Welle vom Dämpfungsglied (14) um einen vorbestimmten Winkel verschiebt, und der die weitere Hilfswelle ausgibt.

10. Verstärker vom Konstantamplitudenwellen-Kombinationstyp nach den Ansprüchen 5 bis 9, wobei
die Ausgabe der Näherungslösungsschaltungseinrichtung (16) durch ein erstes Dämpfungsglied (19) auf einen Dämpfungspegel (1 - a) gedämpft wird, damit sie zur Addierereinrichtung (17) ausgegeben wird;
das Dämpfungsglied (14) der Rückkoppeleinrichtung ein zweites Dämpfungsglied ausbildet; und
die Hilfswellen-Rückkoppeleinrichtung (48) ein drittes Dämpfungsglied (19) mit einem Dämpfungspegel (a) aufweist, das mit der Addiereinrichtung (17) verbunden ist;
wobei die Summe des Dämpfungspegels des ersten Dämpfungsglieds (19) und des Dämpfungspegels des dritten Dämpfungsglieds (18) gleich 1 ist.

11. Verstärker vom Konstantamplitudenwellen-Kombinationstyp nach Anspruch 1, wobei die Hilfswellen-Erzeugungseinrichtung (181) folgendes aufweist:
einen Begrenzerverstärker (161), der die Eingangswelle verstärkt und eine amplitudenbegrenzte Welle ausgibt; und
einen Subtrahierer (162), der eine Differenz zwischen der Eingangswelle und der amplitudenbegrenzten Welle ausgibt, wobei die Differenz der durch die Hilfswellen-Erzeugungseinrichtung erzeugten Hilfs-Eingangswelle entspricht,
wobei die Konstantamplitudenwellen-Erzeugungseinrichtung (182) folgendes aufweist: eine 90°-Hybridschaltung (120) mit einem ersten Eingangsanschluß, der die Eingangswelle empfängt, einem zweiten Eingangsanschluß, der die Hilfs-Eingangswelle empfängt, einem ersten Ausgangsanschluß, der die erste Konstantamplitudenwelle ausgibt, und einem zweiten Ausgangsanschluß, der die zweite Konstantamplitudenwelle ausgibt, und
wobei die erste Wellenkombinationseinrichtung (185) folgendes aufweist: eine -90°-Hybridschaltung (130) mit einem ersten Eingangsanschluß, der die erste verstärkte Ausgabe empfängt, einem zweiten Eingangsanschluß, der zweite verstärkte Ausgabe empfängt, einem ersten Ausgangsanschluß, der die Ausgangswelle ausgibt, und einem zweiten Ausgangsanschluß, der über einen Widerstand (21) abgeschlossen ist.

12. Verstärker vom Konstantamplitudenwellen-Kombinationstyp nach Anspruch 1, wobei die Hilfswellen-Erzeugungseinrichtung (181) folgendes aufweist:
einen Begrenzerschaltungsverstärker (161), der die Eingangswelle verstärkt und eine amplitudenbegrenzte Welle ausgibt;
einen Subtrahierer (162), der eine Differenz zwischen der Eingangswelle und der amplitudenbegrenzten Welle ausgibt, wobei die Differenz der durch die Hilfswellen-Erzeugungseinrichtung erzeugten Hilfs-Eingangswelle entspricht,
wobei der Verstärker vom Konstantamplitudenwellen-Kombinationstyp weiterhin folgendes aufweist: einen 90°-Phasenschieber (155), der eine Phase der Hilfs-Eingangswelle um 90° verschiebt und der die Hilfs-Eingangswelle mit einer um 90° verschobenen Phase zur Konstantamplitudenwellen-Erzeugungseinrichtung (182) ausgibt,
wobei die Konstantamplitudenwellen-Erzeugungseinrichtung (182) folgendes aufweist: eine Gleichphasen-Hybridschaltung (135) mit einem ersten Eingangsanschluß, der die Eingangswelle empfängt, einem zweiten Eingangsanschluß, der die Hilfs-Eingangswelle vom 90°-Phasenschieber empfängt, einem ersten Ausgangsanschluß, der die erste Konstantamplitudenwelle ausgibt, und einem zweiten Ausgangsanschluß, der die zweite Konstantamplitudenwelle ausgibt, und
wobei die erste Wellenkombinationsschaltung (185) folgendes aufweist: eine 90°-Hybridschaltung (145) mit einem ersten Eingangsanschluß, der die erste verstärkte Ausgabe empfängt, einem zweiten Eingangsanschluß, der die zweite verstärkte Ausgabe empfängt, einem ersten Ausgangsanschluß, der die Ausgangswelle ausgibt, und einem zweiten Ausgangsanschluß, der die Hilfs-Ausgangswelle ausgibt.

13. Verstärker vom Konstantamplitudenwellen-Kombinationstyp nach einem der vorangehenden Ansprüche, der folgendes aufweist: eine Korrektureinrichtung (186) zum Erzeugen eines Korrekturwerts (Δ), der eine Verzerrungskomponente anzeigt, die in der Ausgangswelle der Wellenkombinationsschaltung (185) enthalten ist, durch Vergleichen der Eingangswelle mit der Ausgangswelle, und zum Addieren des Korrekturwerts zum Eingangswert, so daß die in der Ausgangswelle enthaltene Verzerrungskomponente gelöscht wird.

14. Verstärker vom Konstantamplitudenwellen-Kombinationstyp nach Anspruch 13, wobei die Korrektureinrichtung (186) folgendes aufweist:
ein Dämpfungsglied (160), das die Ausgangswelle um einen vorbestimmten Dämpfungspegel (1/k) dämpft und das eine gedämpfte Ausgangswelle ausgibt,
einen Subtrahierer (170), der ein Differenzsignal ausgibt, das eine Differenz (Δ) zwischen der gedämpften Ausgangswelle und einer korrigierten Eingangswelle anzeigt; und
einen Addierer (180), der das Differenzsignal und die Eingangswelle addiert und der eine korrigierte Eingangswelle entsprechend einem Additionsergebnis ausgibt, wobei die korrigierte Eingangswelle als die Eingangswelle zur Konstantamplitudenwellen-Erzeugungseinrichtung zugeführt wird und wobei das Differenzsignal dem Korrekturwert entspricht.

15. Verstärker vom Konstantamplitudenwellen-Kombinationstyp nach Anspruch 13, wobei die Korrektureinrichtung (186) folgendes aufweist:
ein Dämpfungsglied (160), das die Ausgangswelle um einen vorbestimmten Dämpfungspegel (1/k) dämpft und das eine gedämpfte Ausgangswelle ausgibt;
einen Subtrahierer (170), der ein Differenzsignal ausgibt, das eine Differenz zwischen der gedämpften Ausgangswelle und der Eingangswelle anzeigt;
einen Begrenzerschaltungsverstärker (220), der das Differenzsignal verstärkt und der ein verstärktes Differenzsignal entsprechend dem Korrekturwert ausgibt; und
einen Addierer (180), der das verstärkte Differenzsignal und die Eingangswelle addiert und der die Eingangswelle mit der verstärkten Differenz zur Konstantamplitudenwellen-Erzeugungseinrichtung ausgibt.

16. Verstärker vom Konstantamplitudenwellen-Kombinationstyp nach einem der vorangehenden Ansprüche, der folgendes aufweist: eine Korrektureinrichtung (188), die zwischen der Hilfswellen-Erzeugungseinrichtung (181) und der Konstantamplitudenwellen-Erzeugungseinrichtung (182) vorgesehen ist, zum Erzeugen eines Korrekturwerts (Δ'), der eine in einer Ausgangswelle der Wellenkombinationsschaltung (187) enthaltene Verzerrungskomponente durch Vergleichen der Ausgangswelle mit der Hilfs-Eingangswelle anzeigt, und zum Addieren des Korrekturwerts zur Hilfs-Eingangswelle, so daß die Hilfs-Eingangswelle, zu der der Korrekturwert addiert worden ist, zur Konstantamplitudenwellen-Erzeugungseinrichtung (182) zugeführt wird, und die in der Ausgangswelle enthaltene Verzerrungskomponente gelöscht wird.

17. Verstärker vom Konstantamplitudenwellen-Kombinationstyp nach Anspruch 16, wobei die Korrektureinrichtung (188) folgendes aufweist:
ein Dämpfungsglied (230), das die Hilfs-Ausgangswelle um einen vorbestimmten Dämpfungspegel (1/k) dämpft und das eine gedämpfte Hilfs-Ausgangswelle ausgibt;
einen Subtrahierer (240), der ein Differenzsignal ausgibt, das eine Differenz (Δ') zwischen der gedämpften Hilfs-Ausgangswelle und einer korrigierten Eingangswelle anzeigt;
einen Begrenzerschaltungsverstärker (250), der das Differenzsignal verstärkt und der ein amplitudenbegrenztes Differenzsignal entsprechend dem Korrekturwert ausgibt; und
einen Addierer (260), der die Hilfs-Eingangswelle und das amplitudenbegrenzte Differenzsignal addiert und der die korrigierte Eingangswelle als die Eingangswelle zur Konstantamplitudenwellen-Erzeugungseinrichtung ausgibt.

18. Verstärker vom Konstantamplitudenwellen-Kombinationstyp nach Anspruch 16, wobei die Korrektureinrichtung (188) folgendes aufweist:
ein Dämpfungsglied (230), das die Hilfs-Ausgangswelle um einen vorbestimmten Dämpfungspegel (1/k) dämpft und das eine gedämpfte Hilfs-Ausgangswelle ausgibt;
einen Subtrahierer (270), der ein Differenzsignal ausgibt, das eine Differenz (Δ') zwischen der gedämpften Hilfs-Ausgangswelle und der Hilfs-Eingangswelle anzeigt, wobei das Differenzsignal dem Korrekturwert entspricht; und
einen Addierer (260), der das Differenzsignal und die Hilfs-Eingangswelle addiert und der die Eingangswelle mit der Differenz zur Konstantamplitudenwellen-Erzeugungseinrichtung ausgibt.

19. Verstärker vom Konstantamplitudenwellen-Kombinationstyp nach einem der vorangehenden Ansprüche, der folgendes aufweist:
eine Regelverstärkereinrichtung (189), die zwischen der Hilfswellen-Erzeugungseinrichtung (181) und der Konstantamplitudenwellen-Erzeugungseinrichtung (182) vorgesehen ist, zum Verstärken der Hilfs-Eingangswelle um eine Verstärkung und zum Ausgeben der Hilfs-Eingangswelle mit einer verstärkten Amplitude zur Konstantamplitudenwellen-Erzeugungseinrichtung (182); und
eine Steuereinrichtung (190) zum Erzeugen eines Korrekturwerts, der eine in einer Ausgangswelle der Wellenkombinationsschaltung (185) enthaltenen Verzerrungskomponente anzeigt, durch Vergleichen der Ausgangswelle mit der Eingangswelle, und zum Steuern der Verstärkung der Regelverstärkereinrichtung (189) auf der Basis des Korrekturwerts, so daß die in der Ausgangswelle enthaltene Verzerrungskomponente gelöscht wird.

20. Verstärker vom Konstantamplitudenwellen-Kombinationstyp nach Anspruch 19, wobei die Steuereinrichtung (190) folgendes aufweist:
ein Dämpfungsglied (323), das die Ausgangswelle um einen vorbestimmten Dämpfungspegel dämpft und das eine gedämpfte Ausgangswelle ausgibt;
eine erste Quadrierschaltung (332), die die gedämpfte Ausgangswelle quadriert und die eine quadrierte gedämpfte Ausgangswelle ausgibt;
eine zweite Quadrierschaltung (331), die die Eingangswelle quadriert und die eine quadrierte Eingangswelle ausgibt; und
einen Subtrahierer (333), der ein Differenzsignal ausgibt, das eine Differenz zwischen der quadrierten gedämpften Ausgangswelle und der quadrierten Eingangswelle anzeigt; und
ein Filter (340), das eine Gleichstromkomponente vom Differenzsignal extrahiert und das die Gleichstromkomponente zur Regelverstärkereinrichtung (189) ausgibt, und
wobei die Regelverstärkereinrichtung (189) einen Verstärker (330) mit automatischer Verstärkungssteuerung aufweist, der eine durch die Gleichstromkomponente gesteuerte variable Verstärkung hat.

21. Verstärker vom Konstantamplitudenwellen-Kombinationstyp nach einem der vorangehenden Ansprüche, der folgendes aufweist:
eine Regelverstärkereinrichtung (189), die zwischen der Hilfswellen-Erzeugungseinrichtung (181) und der Konstantamplitudenwellen-Erzeugungseinrichtung (182) vorgesehen ist, zum Verstärken der Hilfs-Eingangswelle um eine Verstärkung und zum Ausgeben der Hilfs-Eingangswelle mit einer verstärkten Amplitude zur Konstantamplitudenwellen-Erzeugungseinrichtung (182); und
eine Steuereinrichtung (192) zum Erzeugen eines Korrekturwerts, der eine in einer Ausgangswelle der Wellenkombinationsschaltung (185) enthaltene Verzerrungskomponente anzeigt, durch Vergleichen der Ausgangswelle mit der Hilfs-Eingangswelle und zum Steuern der Verstärkung der Regelverstärkereinrichtung (189) auf der Basis des Korrekturwerts, so daß die in der Ausgangswelle enthaltene Verzerrungskomponente gelöscht wird.

22. Verstärker vom Konstantamplitudenwellen-Kombinationstyp nach Anspruch 21, dadurch gekennzeichnet, daß die Steuereinrichtung (192) folgendes aufweist:
ein Dämpfungsglied (327), das die Ausgangswelle um einen vorbestimmten Dämpfungspegel (1/k) dämpft und das eine gedämpfte Ausgangswelle ausgibt;
eine erste Quadrierschaltung (338), die die gedämpfte Ausgangswelle quadriert und die eine quadrierte gedämpfte Ausgangswelle ausgibt;
eine zweite Quadrierschaltung (340), die die Eingangswelle quadriert und die eine quadrierte Hilfs-Eingangswelle ausgibt;
einen Subtrahierer (339), der ein Differenzsignal ausgibt, das eine Differenz zwischen der quadrierten gedämpften Ausgangswelle und der quadrierten Hilfs-Eingangswelle anzeigt; und
ein Filter (341), das eine Gleichstromkomponente vom Differenzsignal extrahiert und das die Gleichstromkomponente zur Regelverstärkereinrichtung (189) ausgibt, und
wobei die Regelverstärkereinrichtung (189) einen Verstärker (330) mit automatischer Verstärkungssteuerung aufweist, der eine durch die Gleichstromkomponente gesteuerte variable Verstärkung hat.

23. Verstärker vom Konstantamplitudenwellen-Kombinationstyp nach einem der vorangehenden Ansprüche, der folgendes aufweist:
eine Regelverstärkereinrichtung (189), die zwischen der Hilfswellen-Erzeugungseinrichtung (181) und der Konstantamplitudenwellen-Erzeugungseinrichtung (182) vorgesehen ist, zum Verstärken der Hilfs-Eingangswelle um eine Verstärkung und zum Ausgeben der Hilfs-Eingangswelle mit einer verstärkten Amplitude zur Konstantamplitudenwellen-Erzeugungseinrichtung (182); und
Erzeugen einer Steuereinrichtung (191) zum Erzeugen eines Korrekturwerts, der eine in einer Ausgangswelle der Wellenkombinationsschaltung (185) enthaltene Verzerrungskomponente anzeigt, durch Vergleichen einer der ersten und zweiten Konstantamplitudenwellen, die durch die Konstantwellen-Erzeugungseinrichtung (182) ausgegeben werden, und der ersten und zweiten verstärkten Ausgaben davon mit einem vorbestimmten Referenzwert (Vo) und zum derartigen Steuern der Verstärkung der Regelverstärkereinrichtung (189), daß die in der Ausgangswelle enthaltene Verzerrungskomponente gelöscht wird.

24. Verstärker vom Konstantamplitudenwellen-Kombinationstyp nach Anspruch 23, dadurch gekennzeichnet, daß die Steuereinrichtung (191) folgendes aufweist:
eine Quadrierschaltung (335), die die eine der ersten und zweiten Konstantamplitudenwellen und der ersten und zweiten verstärkten Ausgaben quadriert und die ein quadriertes Signal ausgibt;
einen Subtrahierer (336), der ein Differenzsignal ausgibt, das eine Differenz zwischen dem quadrierten Signal und dem vorbestimmten Referenzwert (Vo) anzeigt; und
ein Filter (337), das eine Gleichstromkomponente vom Differenzsignal extrahiert und das die Gleichstromkomponente zur Verstärkereinrichtung (189) mit variabler Verstärkung ausgibt, und
wobei die Regelverstärkereinrichtung (189) einen Verstärker (330) mit automatischer Verstärkungssteuerung aufweist, der eine durch die Gleichstromkomponente gesteuerte variable Verstärkung hat.

25. Verstärker vom Konstantamplitudenwellen-Kombinationstyp nach einem der vorangehenden Ansprüche, der weiterhin folgendes aufweist:
einen dritten Verstärker (22; 51; 193; 351), der eine der ersten Konstantamplitudenwelle (A) und der ersten verstärkten Ausgabe (kA) verstärkt und eine dritte verstärkte Ausgabe (mA) erzeugt;
einen vierten Verstärker (23; 52; 194; 352), der eine der zweiten Konstantamplitudenwelle (B) und der zweiten verstärkten Ausgabe (kB) verstärkt und eine vierte verstärkte Ausgabe (mB) erzeugt; und
eine zweite Wellenkombinationseinrichtung (24; 53; 105; 353), die mit dem dritten und dem vierten Verstärker gekoppelt ist, zum Kombinieren der dritten und der vierten verstärkten Ausgaben und zum Erzeugen einer Ausgangswelle (mX), die unterschiedlich von der durch die erste Wellenkombinationseinrichtung erzeugten Ausgangswelle (kX) ist.

## Revendications

1. Amplificateur du type à combinaison d'ondes d'amplitude constante, comprenant
un moyen de génération d'onde d'amplitude constante (46 ; 182) pour combiner une onde d'entrée (X) et une onde d'entrée auxiliaire (Y) et pour générer une première onde d'amplitude constante (A) et une seconde onde d'amplitude constante (B) ;
un premier amplificateur (41 ; 183) amplifiant ladite première onde d'amplitude constante et sortant une première sortie amplifiée (kA) ;
un second amplificateur (42 ; 184) amplifiant ladite seconde onde d'amplitude constante et sortant une seconde sortie amplifiée (kB) ;
un moyen de combinaison d'ondes (47 ; 185 ; 187) couplé auxdits premier et second amplificateurs pour combiner lesdites première et seconde sorties amplifiées et pour générer une onde de sortie (kX) ; et
un moyen de génération d'onde auxiliaire (49 ; 181) couplé audit moyen de génération d'onde d'amplitude constante et générant une onde auxiliaire à partir de ladite onde d'entrée, pour former ladite onde d'entrée auxiliaire comme une onde orthogonale à ladite onde d'entrée.

2. Amplificateur du type à combinaison d'ondes d'amplitude constante selon la revendication 1, dans lequel ledit moyen de génération d'onde d'amplitude constante (46 ; 182) comprend un premier circuit hybride de 90° (12 ; 120 ; 135) comportant une première borne d'entrée recevant ladite onde d'entrée, une seconde borne d'entrée recevant ladite onde d'entrée auxiliaire, une première borne de sortie sortant ladite première onde d'amplitude constante vers ledit premier amplificateur et une seconde borne de sortie sortant ladite seconde onde d'amplitude constante vers ledit second amplificateur.

3. Amplificateur du type à combinaison d'ondes d'amplitude constante selon la revendication 1 ou 2, dans lequel ledit moyen de combinaison d'onde (47 ; 185 ; 187) comprend un second circuit hybride de 90° (13 ; 130 ; 145) comportant une première borne d'entrée recevant ladite première sortie amplifiée et une seconde borne d'entrée recevant ladite seconde sortie amplifiée.

4. Amplificateur du type à combinaison d'ondes d'amplitude constante selon la revendication 3, dans lequel ledit second circuit hybride de 90° (13 ; 130 ; 145) comporte une première borne de sortie sortant ladite onde de sortie, et une seconde borne de sortie qui se termine via une résistance (21).

5. Amplificateur du type à combinaison d'ondes d'amplitude constante selon l'une quelconque des revendications précédentes, dans lequel ledit moyen de génération d'onde auxiliaire (moyen (49 ; 181)) comprend
un moyen de circuit de solution approchée (16) pour générer une solution approchée indicative d'une amplitude d'une onde orthogonale (Y) orthogonale à ladite onde d'entrée (X) ;
dans lequel ladite solution approchée correspond à ladite onde auxiliaire générée par ledit moyen de génération d'onde auxiliaire.

6. Amplificateur du type à combinaison d'ondes d'amplitude constante selon l'une quelconque des revendications précédentes, dans lequel ledit moyen de génération d'onde auxiliaire (49 ; 181) comprend
un amplificateur limiteur (161) qui amplifie ladite onde d'entrée et sort une onde d'amplitude limitée ; et
un soustracteur (162) qui sort une différence entre ladite onde d'entrée et ladite onde d'amplitude limitée, ladite différence correspondant à ladite onde d'entrée auxiliaire formée par ledit moyen de génération d'onde auxiliaire.

7. Amplificateur du type à combinaison d'ondes d'amplitude constante selon la revendication 1, comprenant en outre
un moyen de contre-réaction d'onde auxiliaire (48) couplé audit moyen de combinaison d'onde (47) et audit moyen de génération d'onde d'amplitude constante (46) et renvoyant ladite onde de sortie auxiliaire sous forme d'une onde auxiliaire supplémentaire ; et
un moyen d'additionneur (17) couplé audit moyen de génération d'onde auxiliaire (49) et audit moyen de contre-réaction d'onde auxiliaire (48) pour ajouter ladite onde auxiliaire délivrée par ledit moyen de génération d'onde auxiliaire (49) et ladite onde auxiliaire supplémentaire délivrée par ledit moyen de contre-réaction d'onde auxiliaire (48) de manière à former ladite onde d'entrée auxiliaire délivrée audit moyen générateur d'onde d'amplitude constante (46).

8. Amplificateur du type à combinaison d'ondes d'amplitude constante selon la revendication 7, dans lequel ledit moyen de contre-réaction d'onde auxiliaire comprend un atténuateur (14 ; 230 ; 323 ; 327) qui atténue ladite onde auxiliaire supplémentaire d'un niveau prédéterminé (1/k).

9. Amplificateur du type à combinaison d'ondes d'amplitude constante selon la revendication 8, dans lequel ledit moyen de contre-réaction d'onde auxiliaire comprend un dispositif de décalage de phase (15) qui décale la phase d'une onde à partir dudit atténuateur (14) d'un angle prédéterminé et qui sort ladite onde auxiliaire supplémentaire.

10. Amplificateur du type à combinaison d'ondes d'amplitude constante selon la revendication 5 ou 9, dans lequel
la sortie dudit moyen de circuit de solution approchée (16) est atténuée par un premier atténuateur (19) à un niveau d'atténuation (1 - α) pour être sortie vers ledit moyen d'additionneur (17) ;
ledit atténuateur (14) dudit moyen de contre-réaction forme un second atténuateur ; et
ledit moyen de contre-réaction d'onde auxiliaire (48) comprend un troisième atténuateur (19) d'un niveau d'atténuation (a) relié audit moyen d'additionneur (17) ;
dans lequel la somme du niveau d'atténuation dudit premier atténuateur (19) et du niveau d'atténuation dudit troisième atténuateur (18) est égale à 1.

11. Amplificateur du type à combinaison d'ondes d'amplitude constante selon la revendication 1, dans lequel ledit moyen générateur d'onde auxiliaire (181) comprend :
un amplificateur limiteur (161) qui amplifie ladite onde d'entrée et sort une onde d'amplitude limitée ; et
un soustracteur (162) qui sort une différence entre ladite onde d'entrée et ladite onde d'amplitude limitée, ladite différence correspondant à ladite onde d'entrée auxiliaire générée par ledit moyen générateur d'onde auxiliaire,
dans lequel ledit moyen générateur d'onde d'amplitude constante (182) comprend un circuit hybride de 90° (120) comportant une première borne d'entrée recevant ladite onde d'entrée, et une seconde borne d'entrée recevant ladite onde d'entrée auxiliaire, une première borne de sortie sortant ladite première onde d'amplitude constante et une seconde borne de sortie sortant ladite seconde onde d'amplitude constante, et
dans lequel ledit premier moyen de combinaison d'ondes (185) comprend un circuit hybride de -90° (130) comprenant une première borne d'entrée recevant ladite première sortie amplifiée, une seconde borne d'entrée recevant ladite seconde sortie amplifiée, une première borne de sortie sortant ladite onde de sortie et une seconde borne de sortie qui se termine via une résistance (21).

12. Amplificateur du type à combinaison d'ondes d'amplitude constante selon la revendication 1, dans lequel ledit moyen générateur d'onde auxiliaire (181) comprend un amplificateur limiteur (161) qui amplifie ladite onde d'entrée et sort une onde d'amplitude limitée ; et
un soustracteur (162) qui sort une différence entre ladite onde d'entrée et ladite onde d'amplitude limitée, ladite différence correspondant à ladite onde d'entrée auxiliaire générée par ledit moyen générateur d'onde auxiliaire,
dans lequel ledit amplificateur du type à combinaison d'ondes d'amplitude constante comprend en outre un dispositif de décalage de phase de 90° (155) qui décale une phase de ladite onde d'entrée auxiliaire de 90° et qui sort ladite onde d'entrée auxiliaire ayant une phase décalée de 90° vers ledit moyen générateur d'onde d'amplitude constante (182), dans lequel ledit moyen générateur d'onde d'amplitude constante (182) comprend un circuit hybride-en phase (135) comprenant une première borne d'entrée recevant ladite onde d'entrée, une seconde borne d'entrée recevant ladite onde d'entrée auxiliaire en provenance dudit dispositif de décalage de phase de 90°, une première borne de sortie sortant ladite première onde d'amplitude constante et une seconde borne de sortie sortant ladite seconde onde d'amplitude constante, et
dans lequel ledit premier moyen de combinaison d'onde (185) comprend un circuit hybride de 90° (145) comportant une première borne d'entrée recevant ladite première sortie amplifiée, une seconde borne d'entrée recevant ladite seconde sortie amplifiée, une première borne de sortie sortant ladite onde de sortie et une seconde borne de sortie qui sort ladite onde de sortie auxiliaire.

13. Amplificateur du type à combinaison d'ondes d'amplitude constante selon l'une quelconque des revendications précédentes, comprenant un moyen de correction (186) pour générer une valeur de correction (Δ) indicative d'une composante de distorsion contenue dans l'onde de sortie dudit circuit combinateur d'onde (185) en comparant l'onde d'entrée à ladite onde de sortie et en ajoutant ladite valeur de correction à ladite valeur d'entrée de telle manière que ladite composante de distorsion contenue dans ladite onde de sortie soit annulée.

14. Amplificateur du type à combinaison d'ondes d'amplitude constante selon la revendication 13, dans lequel ledit moyen de correction (186) comprend :
un atténuateur (160) qui atténue ladite onde de sortie d'un niveau d'atténuation prédéterminé (1/k) et qui sort une onde de sortie atténuée ;
un soustracteur (170) qui sort un signal de différence indicatif d'une différence (Δ) entre ladite onde de sortie atténuée et une onde d'entrée corrigée ; et
un additionneur (180) qui ajoute ledit signal de différence et ladite onde d'entrée et qui sort une onde d'entrée corrigée correspondant à un résultat d'addition, ladite onde d'entrée corrigée étant délivrée, sous forme de ladite onde d'entrée, audit moyen générateur d'onde d'amplitude constante et ledit signal de différence correspondant à ladite valeur de correction.

15. Amplificateur du type à combinaison d'ondes d'amplitude constante selon la revendication 13, dans lequel ledit moyen de correction (186) comprend :
un atténuateur (160) qui atténue ladite onde de sortie d'un niveau d'atténuation prédéterminé (1/k) et qui sort une onde de sortie atténuée ;
un soustracteur (170) qui sort un signal de différence indicatif d'une différence entre ladite onde de sortie atténuée et ladite onde d'entrée ;
un amplificateur limiteur (220) qui amplifie ledit signal de différence et qui sort un signal de différence amplifié correspondant à ladite valeur de correction ; et
un additionneur (180) qui ajoute ledit signal de différence amplifié et ladite onde d'entrée et qui sort ladite onde d'entrée ayant ladite différence amplifiée vers ledit moyen générateur d'onde d'amplitude constante.

16. Amplificateur du type à combinaison d'ondes d'amplitude constante selon l'une quelconque des revendications précédentes, comprenant un moyen de correction (188), disposé entre ledit moyen générateur d'onde auxiliaire (181) et ledit moyen générateur d'onde d'amplitude constante (182) pour générer une valeur de correction (Δ') indicative d'une composante de distorsion contenue dans une onde de sortie dudit circuit combinateur d'ondes (187) en comparant ladite onde de sortie à ladite onde d'entrée auxiliaire et pour ajouter ladite valeur de correction à ladite onde d'entrée auxiliaire, de telle manière que ladite onde d'entrée auxiliaire à laquelle ladite valeur de correction a été ajoutée soit délivrée audit moyen générateur d'onde d'amplitude constante (182) et que ladite composante de distorsion contenue dans ladite onde de sortie soit annulée.

17. Amplificateur du type à combinaison d'ondes d'amplitude constante selon la revendication 16, dans lequel ledit moyen de correction (188) comprend :
un atténuateur (230) qui atténue ladite onde de sortie auxiliaire d'un niveau d'atténuation prédéterminé (1/k) et qui sort une onde de sortie auxiliaire atténuée ;
un soustracteur (240) qui sort un signal de différence indicatif d'une différence (Δ') entre ladite onde de sortie auxiliaire atténuée et une onde d'entrée corrigée ;
un amplificateur limiteur (250) qui amplifie ledit signal de différence et qui sort un signal de différence d'amplitude limitée correspondant à ladite valeur de correction ; et
un additionneur (260) qui ajoute ladite onde d'entrée auxiliaire et ledit signal de différence d'amplitude limitée et qui sort ladite onde d'entrée corrigée vers ledit moyen générateur d'onde d'amplitude constante sous forme de ladite onde d'entrée.

18. Amplificateur du type à combinaison d'ondes d'amplitude constante selon la revendication 16, dans lequel ledit moyen de correction (188) comprend :
un atténuateur (130) qui atténue ladite onde de sortie auxiliaire d'un niveau d'atténuation prédéterminé (1/k) et qui sort une onde de sortie auxiliaire atténuée ;
un soustracteur (270) qui sort un signal de différence indicatif d'une différence (Δ') entre ladite onde de sortie auxiliaire atténuée et ladite onde d'entrée auxiliaire, ledit signal de différence correspondant à ladite valeur de correction ; et
un additionneur (260) qui ajoute ledit signal de différence et ladite onde d'entrée auxiliaire et qui sort ladite onde d'entrée ayant ladite différence vers ledit moyen générateur d'onde d'amplitude constante.

19. Amplificateur du type à combinaison d'onde d'amplitude constante selon l'une quelconque des revendications précédentes, comprend
un moyen amplificateur à gain variable (189), disposé entre ledit moyen générateur d'onde auxiliaire (181) et ledit moyen générateur d'onde d'amplitude constante (182) pour amplifier ladite onde d'entrée auxiliaire d'un certain gain et pour sortir ladite onde d'entrée auxiliaire ayant une amplitude amplifiée vers ledit moyen générateur d'onde d'amplitude constante (182) ; et
un moyen de commande (190) pour générer une valeur de correction indicative d'une composante de distorsion contenue dans une onde de sortie dudit circuit combinateur d'ondes (185) en comparant ladite onde de sortie à ladite onde d'entrée et pour commander le gain dudit moyen amplificateur à gain variable (189) sur ladite base de ladite valeur de correction de telle façon que ladite composante de distorsion contenue dans ladite onde de sortie soit annulée.

20. Amplificateur du type à combinaison d'ondes d'amplitude constante selon la revendication 19, dans lequel ledit moyen de commande (190) comprend :
un atténuateur (323) qui atténue ladite onde de sortie d'un niveau d'atténuation prédéterminé et qui sort une onde de sortie atténuée ;
un premier circuit d'élévation au carré (332) qui élève au carré ladite onde de sortie atténuée élevée au carré ;
un second circuit d'élévation au carré (331) qui élève au carré ladite onde d'entrée et qui sort une onde d'entrée élevée au carré ;
un soustracteur (333) qui sort un signal de différence indicatif d'une différence entre ladite onde de sortie atténuée élevée au carré et ladite onde d'entrée élevée au carré ; et
un filtre (340) qui extrait une composante C.C. dudit signal de différence et qui sort ladite composante C.C. vers ledit moyen amplificateur à gain variable (189), et
dans lequel ledit moyen amplificateur à gain variable (189) comprend un amplificateur de commande automatique du gain (330) ayant un gain variable commandé par ladite composante C.C..

21. Amplificateur du type à combinaison d'ondes d'amplitude constante selon l'une quelconque des revendications précédentes, comprenant
un moyen amplificateur 0 gain variable (189) disposé entre ledit moyen générateur d'onde auxiliaire (181) et ledit moyen générateur d'onde d'amplitude constante (182) pour amplifier ladite onde d'entrée auxiliaire d'un certain gain et pour sortir ladite onde d'entrée auxiliaire ayant une amplitude amplifiée vers ledit moyen générateur d'onde d'amplitude constante (182) ; et
un moyen de commande (192) pour générer une valeur de correction indicative d'une composante de distorsion contenue dans une onde de sortie dudit circuit combinateur d'ondes (185) en comparant ladite onde de sortie à ladite onde d'entrée auxiliaire et pour commander le gain dudit moyen amplificateur 0 gain variable (189) sur la base de ladite valeur de correction de telle manière que ladite composante de distorsion contenue dans ladite onde de sortie soit annulée.

22. Amplificateur du type à combinaison d'ondes d'amplitude constante selon la revendication 21, caractérisé en ce que ledit moyen de commande (192) comprend :
un atténuateur (327) qui atténue ladite onde de sortie d'un niveau d'atténuation prédéterminé (1/k) et qui sort une onde de sortie atténuée ;
un premier circuit d'élévation au carré (338) qui élève au carré ladite onde de sortie atténuée et qui sort une onde de sortie atténuée élevée au carré ;
un second circuit d'élévation au carré (340) qui élève au carré ladite onde d'entrée et qui sort une onde d'entrée auxiliaire élevée au carré ;
un soustracteur (339) qui sort un signal de différence indicatif d'une différence entre ladite onde de sortie atténuée élevée au carré et ladite onde d'entrée auxiliaire élevée au carré ; et
un filtre (341) qui extrait une composante C.C. dudit signal de différence et qui sort ladite composante C.C. vers ledit moyen amplificateur à gain variable (189), et
dans lequel ledit moyen amplificateur à gain variable (189) comprend un amplificateur de commande automatique du gain (330) ayant un gain variable commandé par ladite composante C.C..

23. Amplificateur du type à combinaison d'ondes d'amplitude constante selon l'une quelconque des revendications précédentes, comprenant
un moyen amplificateur à gain variable (189) disposé entre ledit moyen générateur d'onde auxiliaire (181) et ledit moyen générateur d'onde d'amplitude constante (182) pour amplifier ladite onde d'entrée auxiliaire d'un certain gain et pour sortir ladite onde d'entrée auxiliaire ayant une amplitude amplifiée vers ledit moyen générateur d'onde d'amplitude constante (182) ; et
un moyen de commande (191) pour générer une valeur de correction indicative d'une composante de distorsion contenue dans une onde de sortie dudit circuit combinateur d'ondes (185) en comparant l'une des première et seconde ondes d'amplitude constante sorties par ledit moyen générateur d'onde constante (182) et lesdites première et seconde sorties amplifiées de celui-ci à une valeur de référence prédéterminée (Vo) et pour commander le gain dudit moyen amplificateur à gain variable (189) de telle manière que ladite composante de distorsion contenue dans ladite onde de sortie soit annulée.

24. Amplificateur du type à combinaison d'ondes d'amplitude constante selon la revendication 23, caractérisé en ce que ledit moyen de commande (191) comprend :
un premier circuit d'élévation au carré (335) qui élève au carré une desdites première et seconde ondes d'amplitude constante et une desdites première et seconde sorties amplifiées et qui sort un signal élevé au carré ;
un soustracteur (336) qui sort un signal de différence indicatif d'une différence entre ledit signal élevé au carré et ladite valeur de référence prédéterminée (Vo) ; et
un filtre (337) qui extrait une composante C.C. dudit signal de différence et qui sort ladite composante C.C. vers ledit moyen amplificateur à gain variable (189), et
dans lequel ledit moyen amplificateur à gain variable (189) comprend un amplificateur de commande automatique du gain (330) ayant un gain variable commandé par ladite composante C.C..

25. Amplificateur du type à combinaison d'ondes d'amplitude constante selon l'une quelconque des revendications précédentes, comprenant en outre :
un troisième amplificateur (22 ; 51 ; 193 ; 351) amplifiant l'une de ladite première onde d'amplitude constante (A) et de ladite première sortie amplifiée (kA) et générant une troisième sortie amplifiée (mA) ;
un quatrième amplificateur (23 ; 52 ; 194 ; 352) amplifiant l'une de ladite seconde onde d'amplitude constante (B) et de ladite seconde sortie amplifiée (kB) et générant une quatrième sortie amplifiée (mB) ; et
un second moyen combinateur d'ondes (24, 53 ; 105 ; 353) couplé auxdits troisième et quatrième amplificateurs pour combiner lesdites troisième et quatrième sorties amplifiées et pour générer une onde de sortie (mX) qui est différente de ladite onde de sortie (kX) générée par ledit premier moyen combinateur d'ondes.
